# EUROPEAN PATENT APPLICATION

(11) **EP 3 975 255 A1**
(43) Date of publication of application: **30.03.2022**
(21) Application number: 21182547.6
(22) Date of filing: 29.06.2021
(51) Int. Cl.: H01L 27/11573, H01L 27/11582, H01L 23/00, H01L 27/11575, H01L 27/11565

(54) **SEMICONDUCTOR DEVICE AND ELECTRONIC SYSTEM INCLUDING THE SAME**

(30) Priority: 23.09.2020 KR 20200123080
(71) Applicant: Samsung Electronics Co., Ltd., Suwon-si, Gyeonggi-do 16677 (KR)
(72) Inventor: KIM, Junhyoung, 16677 Suwon-si (KR); KIM, Chanho, 16677 Suwon-si (KR); YUN, Kyunghwa, 16677 Suwon-si (KR); KIM, Dongseong, 16677 Suwon-si (KR)
(74) Representative: Mounteney, Simon James

(57) **Abstract**

A semiconductor device and an electronic system are disclosed. The semiconductor device includes a semiconductor substrate; a peripheral circuit structure including peripheral circuits integrated on the semiconductor substrate, and a landing pad connected to the peripheral circuits; a semiconductor layer on the peripheral circuit structure; a metal structure in contact with a portion of the semiconductor layer, the metal structure including first portions extending in a first direction, second portions connected to the first portions and extending in a second direction crossing the first direction, and a via portion vertically extending from at least one of the first and second portions and being connected to the landing pad; and a stack including insulating layers and electrodes vertically and alternately stacked on the metal structure.

## Description

### BACKGROUND

### 1. Field

Embodiments relate to a semiconductor device and an electronic system including the same.

### 2. Description of the Related Art

A semiconductor device capable of storing a large amount of data may be as a part of an electronic system. Accordingly, increasing the data storage capacity of the semiconductor device has been considered. For example, semiconductor devices, in which memory cells are three-dimensionally arranged, have been considered.

### SUMMARY

The embodiments may be realized by providing a semiconductor device including a semiconductor substrate; a peripheral circuit structure including peripheral circuits integrated on the semiconductor substrate, and a landing pad connected to the peripheral circuits; a semiconductor layer on the peripheral circuit structure; a metal structure in contact with a portion of the semiconductor layer, the metal structure including first portions extending in a first direction, second portions connected to the first portions and extending in a second direction crossing the first direction, and a via portion vertically extending from at least one of the first and second portions and being connected to the landing pad; and a stack including insulating layers and electrodes vertically and alternately stacked on the metal structure.

The embodiments may be realized by providing a semiconductor device including a semiconductor substrate; a peripheral circuit structure including peripheral circuits integrated on the semiconductor substrate, and a landing pad connected to the peripheral circuits; a semiconductor layer on the peripheral circuit structure; a first insulating pattern penetrating one portion of the semiconductor layer and extending in a first direction; a metal structure in contact with another portion of the semiconductor layer, the metal structure including first portions extending in the first direction, and second portions connected to the first portions and extending in a second direction crossing the first direction; and a stack including insulating layers and electrodes vertically and alternately stacked on the metal structure, wherein the second portions of the metal structure cross the first insulating pattern.

The embodiments may be realized by providing a semiconductor device a semiconductor substrate; a peripheral circuit structure including a peripheral circuit integrated on the semiconductor substrate, and a landing pad connected to the peripheral circuit; a semiconductor layer on the peripheral circuit structure; a metal structure in contact with a portion of the semiconductor layer, the metal structure including first portions extending in a first direction, second portions connected to the first portions and extending in a second direction crossing the first direction, and a via portion vertically extending from at least one of the first and second portions and connected to the landing pad; a stack including insulating layers and electrodes vertically and alternately stacked on the metal structure; a vertical semiconductor pattern penetrating the stack; a source structure between the semiconductor layer and the stack, the source structure including first and second source conductive patterns sequentially stacked on the semiconductor layer, the first source conductive pattern being in contact with a portion of a side surface of the vertical semiconductor pattern; a data storage pattern between the vertical semiconductor pattern and the stack; a first insulating pattern penetrating the semiconductor layer, below the stack; a first pad pattern in the first insulating pattern and electrically connected to the peripheral circuits; a second pad pattern spaced apart from the stack and the semiconductor layer and electrically connected to the peripheral circuits; a first penetration plug penetrating the stack and connected to the first pad pattern; a second penetration plug spaced apart from the stack and connected to the second pad pattern; and a third penetration plug spaced apart from the stack and connected to the metal structure.

The embodiments may be realized by providing an electronic system including a semiconductor device; and a controller, wherein the semiconductor device includes a semiconductor substrate; a peripheral circuit structure including a peripheral circuit integrated on the semiconductor substrate and a landing pad connected to the peripheral circuit; a semiconductor layer on the peripheral circuit structure; a metal structure in contact with a portion of the semiconductor layer, the metal structure including first portions extending in a first direction, second portions connected to the first portions and extending in a second direction crossing the first direction, and a via portion vertically extending from at least one of the first and second portions and connected to the landing pad; a stack including insulating layers and electrodes vertically and alternately stacked on the metal structure; and an input/output pad electrically connected to the peripheral circuit, and wherein the controller is connected to the semiconductor device through the input/output pad to control the semiconductor device.

At least some of the above and other features of the invention are set out in the claims.

### BRIEF DESCRIPTION OF THE DRAWINGS

Features will be apparent to those of skill in the art by describing in detail example embodiments with reference to the attached drawings in which:
FIG. 1 is a diagram of an electronic system including a semiconductor device according to an embodiment.
FIG. 2 is a perspective view of an electronic system including a semiconductor device according to an embodiment.
FIGS. 3 and 4 are sectional views of semiconductor packages according to an embodiment.
FIG. 5 is a plan view of a semiconductor device according to an embodiment.
FIG. 6 is a plan view of a semiconductor layer, a metal structure, and pad patterns of a semiconductor device according to an embodiment.
FIGS. 7, 8, and 9 are sectional views of a semiconductor device according to an embodiment.
FIGS. 10 to 14 are enlarged sectional views of some examples of a semiconductor device according to an embodiment.
FIGS. 15, 16, and 17 are sectional views of a semiconductor device according to an embodiment.
FIG. 18 is an enlarged sectional view of a semiconductor device according to an embodiment.
FIGS. 19, 20, and 21 are sectional views of a semiconductor device according to an embodiment.
FIG. 22 is an enlarged sectional view of a semiconductor device according to an embodiment.
FIGS. 23, 24, and 25 are sectional views of a semiconductor device according to an embodiment.
FIG. 26 is an enlarged sectional view of a semiconductor device according to an embodiment.
FIGS. 27A to 33A and FIGS. 27B to 33B are sectional views of stages in a method of fabricating a semiconductor device, according to an embodiment.
FIGS. 34A to 37A and FIGS. 34B to 37B are sectional views of stages in a method of fabricating a semiconductor device, according to an embodiment.
FIGS. 38A to 41A and FIGS. 38B to 41B are sectional views of stages in a method of fabricating a semiconductor device, according to an embodiment.

### DETAILED DESCRIPTION

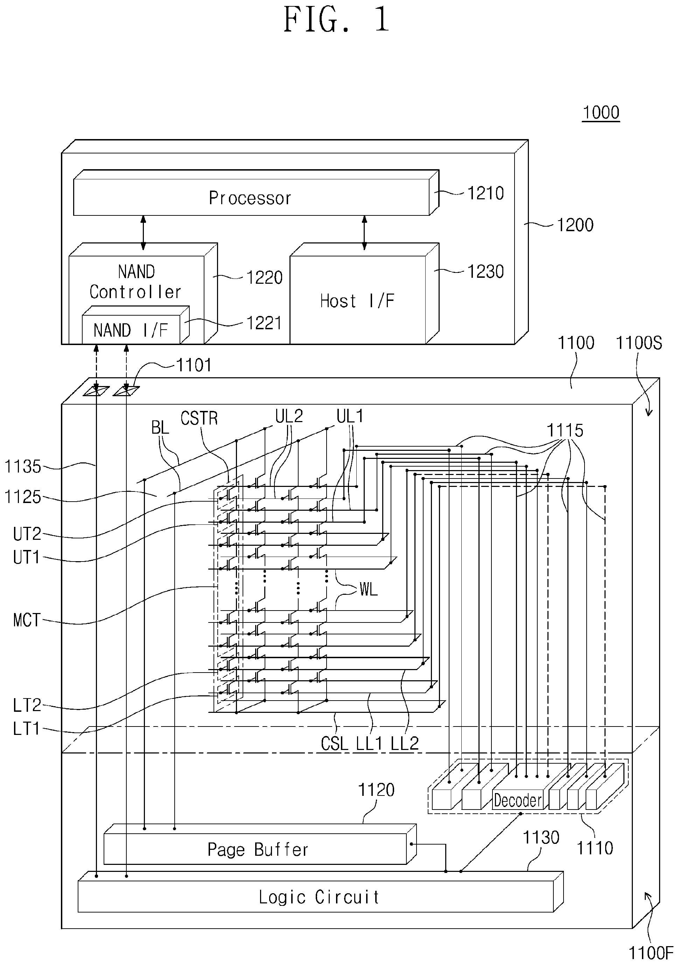

FIG. 1 is a diagram schematically of an electronic system including a semiconductor device according to an embodiment.

Referring to FIG. 1, an electronic system 1000 according to an embodiment may include a semiconductor device 1100 and a controller 1200, which are electrically connected to each other. The electronic system 1000 may be a storage device, in which at least one semiconductor device 1100 is provided, or may be an electronic device including the storage device. In an implementation, the electronic system 1000 may be a solid state drive (SSD) device, a universal serial bus (USB) device, a computing system, a medical system, or a communication system, in which at least one semiconductor device 1100 is provided.

The semiconductor device 1100 may be a nonvolatile memory device (e.g., a NAND FLASH memory device). The semiconductor device 1100 may include a first structure 1100F and a second structure 1100S on the first structure 1100F. In an implementation, the first structure 1100F may be at a side of the second structure 1100S. The first structure 1100F maybe a peripheral circuit structure, and may include a decoder circuit 1110, a page buffer 1120, and a logic circuit 1130. The second structure 1100S may be a memory cell structure, and may include a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of the lower transistors LT1 and LT2 and the number of the upper transistors UT1 and UT2 may be variously changed, according to embodiments.

In an implementation, the upper transistors UT1 and UT2 may include a string selection transistor, and the lower transistors LT1 and LT2 may include a ground selection transistor. The gate lower lines LL1 and LL2 may be respectively used as gate electrodes of the lower transistors LT1 and LT2. The word lines WL may be respectively used as gate electrodes of the memory cell transistors MCT, and the gate upper lines UL1 and UL2 may be respectively used as gate electrodes of the upper transistors UT1 and UT2.

In an implementation, the lower transistors LT1 and LT2 may include a lower erase control transistor LT1 and a ground selection transistor LT2, which are connected in series. The upper transistors UT1 and UT2 may include a string selection transistor UT1 and an upper erase control transistor UT2, which are connected in series. At least one of the lower erase control transistor LT1 and the upper erase control transistor UT2 may be used to perform an erase operation, in which data stored in the memory cell transistors MCT is erased using a gate-induced drain leakage (GIDL) phenomenon.

The common source line CSL, the first and second gate lower lines LL1 and LL2, the word lines WL, and the first and second gate upper lines UL1 and UL2 may be electrically connected to the decoder circuit 1110 through first connection lines 1115, which are extended from a region in the first structure 1100F to a region in the second structure 1100S. The bit lines BL may be electrically connected to the page buffer 1120 through second connection lines 1125, which may extend from a region in the first structure 1100F to a region in the second structure 1100S.

In the first structure 1100F, the decoder circuit 1110 and the page buffer 1120 may be configured to control a control operation, which may be performed on at least one of the memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output connection line 1135, which may be provided in the first structure 1100F and is extended into the second structure 1100S.

The controller 1200 may include a processor 1210, a NAND controller 1220, and a host interface 1230. In an implementation, the electronic system 1000 may include a plurality of semiconductor devices 1100, and in this case, the controller 1200 may control the semiconductor devices 1100.

The processor 1210 may control overall operations the electronic system 1000 including the controller 1200. The processor 1210 may be operated depending on a specific firmware, and may control the NAND controller 1220 to access the semiconductor device 1100. The NAND controller 1220 may include a NAND interface 1221, which is used to communicate with the semiconductor device 1100. The NAND interface 1221 may be used to transmit and receive control commands to control the semiconductor device 1100, data to be written in or read from the memory cell transistors MCT of the semiconductor device 1100, and so forth. The host interface 1230 may be configured to allow for communication between the electronic system 1000 and an external host. When a control command is received from external host through the host interface 1230, the processor 1210 may be control the semiconductor device 1100 in response to the control command.

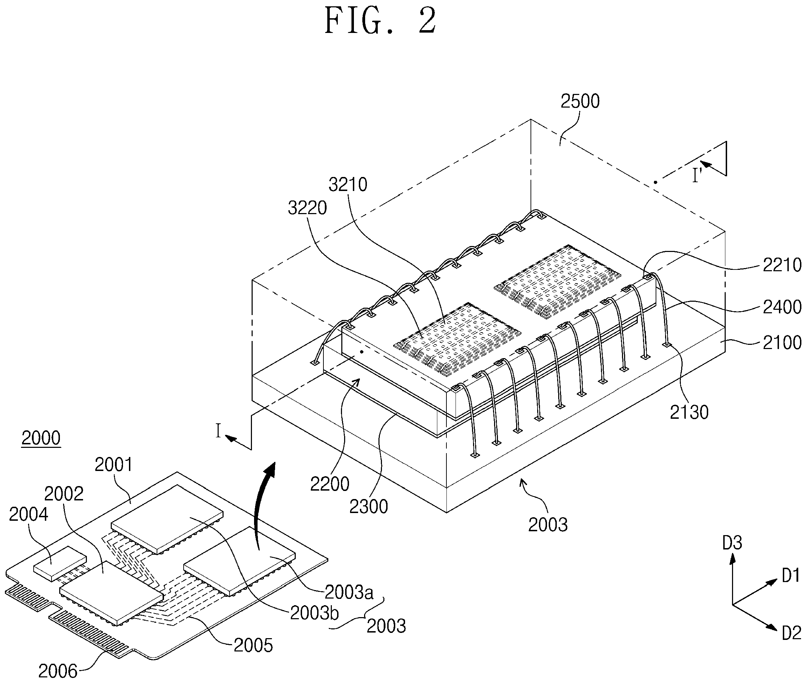

FIG. 2 is a perspective view of an electronic system including a semiconductor device according to an embodiment.

Referring to FIG. 2, an electronic system 2000 according to an embodiment may include a main substrate 2001 and a controller 2002, at least one semiconductor package 2003, and a DRAM 2004, which are mounted on the main substrate 2001. The semiconductor package 2003 and the dynamic random-access memory (DRAM) 2004 may be connected to the controller 2002 through interconnection patterns 2005, which may be on or in the main substrate 2001.

The main substrate 2001 may include a connector 2006, which may include a plurality of pins coupled to an external host. In the connector 2006, the number and arrangement of the pins may depend on a communication interface between the electronic system 2000 and the external host. In an implementation, the electronic system 2000 may communicate with the external host, in accordance with one of interfaces, such as universal serial bus (USB), peripheral component interconnect express (PCI-Express), serial advanced technology attachment (SATA), universal flash storage (UFS) M-Phy, or the like. In an implementation, the electronic system 2000 may be driven by a power, which is supplied from the external host through the connector 2006. The electronic system 2000 may further include a power management integrated circuit (PMIC), which is used to separately supply power, which is provided from the external host, to the controller 2002 and the semiconductor package 2003.

The controller 2002 may be configured to control a writing or reading operation on the semiconductor package 2003 and to improve an operation speed of the electronic system 2000.

The DRAM 2004 may be a buffer memory, which relieves technical difficulties caused by a difference in speed between the semiconductor package 2003, which serves as a data storage device, and an external host. In an embodiment, the DRAM 2004 in the electronic system 2000 may serve as a cache memory and may provide a storage space to temporarily store data during a control operation on the semiconductor package 2003. In the case where the electronic system 2000 includes the DRAM 2004, the controller 2002 may further include a DRAM controller to control the DRAM 2004, in addition to a NAND controller to controlling the semiconductor package 2003.

The semiconductor package 2003 may include first and second semiconductor packages 2003a and 2003b, which are spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chips 2200 on the package substrate 2100, adhesive layers 2300 respectively disposed on bottom surfaces of the semiconductor chips 2200, a connection structure 2400 electrically connecting the semiconductor chips 2200 to the package substrate 2100, and a molding layer 2500 disposed on the package substrate 2100 to cover the semiconductor chips 2200 and the connection structure 2400.

The package substrate 2100 may be a printed circuit board including package upper pads 2130. Each of the semiconductor chips 2200 may include an input/output pad 2210. The input/output pad 2210 may correspond to the input/output pad 1101 of FIG. 1. Each of the semiconductor chips 2200 may include stacks 3210 and vertical structures 3220. Each of the semiconductor chips 2200 may include a semiconductor device, which will be described below, according to an embodiment.

In an implementation, the connection structure 2400 may be a bonding wire electrically connecting the input/output pad 2210 to the package upper pads 2130. In an implementation, in each of the first and second semiconductor packages 2003a and 2003b, the semiconductor chips 2200 may be electrically connected to each other in a bonding wire manner and may be electrically connected to the package upper pads 2130 of the package substrate 2100. In an implementation, the semiconductor chips 2200 in each of the first and second semiconductor packages 2003a and 2003b may be electrically connected to each other by a connection structure including through silicon vias (TSVs), not by the connection structure 2400 provided in the formed of bonding wires.

In an implementation, the controller 2002 and the semiconductor chips 2200 may be included in a single package. In an implementation, the controller 2002 and the semiconductor chips 2200 may be mounted on a separate interposer substrate, which is prepared regardless of the main substrate 2001, and may be connected to each other through interconnection lines, which are provided in the interposer substrate.

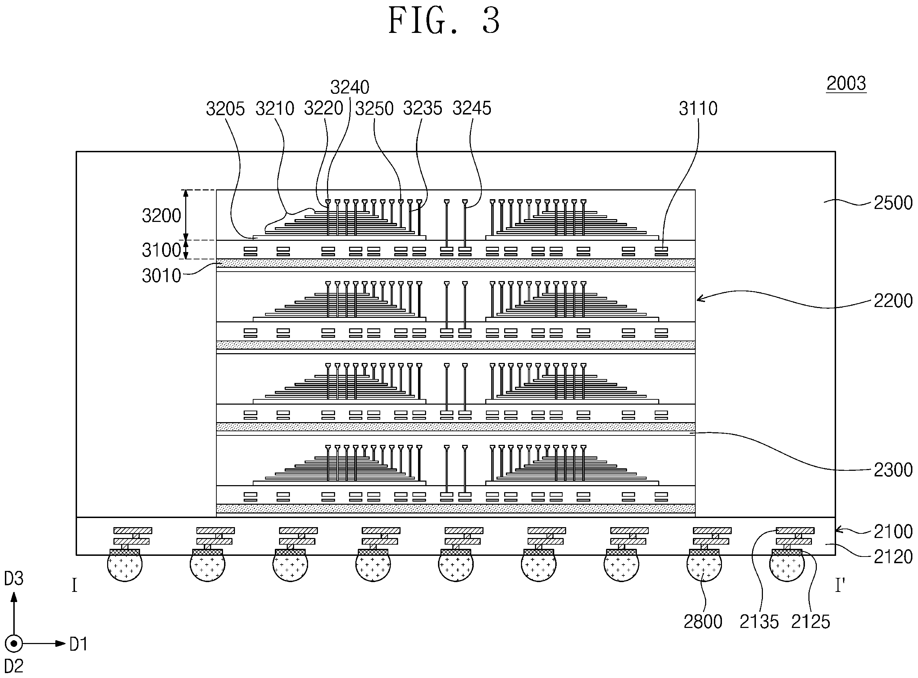

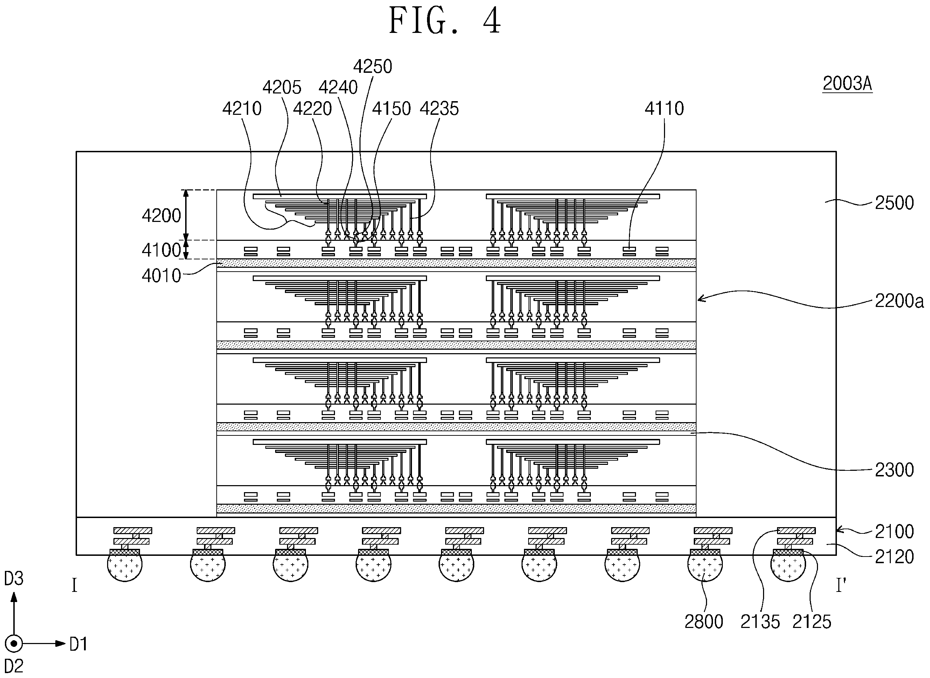

FIGS. 3 and 4 are sectional views of semiconductor packages according to an embodiment. Each of FIGS. 3 and 4 illustrates a schematic cross-section of a portion (e.g., taken along a line I-I' of FIG. 2) of the semiconductor package 2003 of FIG. 2.

Referring to FIG. 3, in the semiconductor package 2003, the package substrate 2100 may be a printed circuit board. The package substrate 2100 may include a package substrate body portion 2120, the package upper pads 2130 (e.g., of FIG. 2) on a top surface of the package substrate body portion 2120, lower pads 2125 on or exposed through a bottom surface of the package substrate body portion 2120, and internal lines 2135 in the package substrate body portion 2120 to electrically connect the package upper pads 2130 to the lower pads 2125. The package upper pads 2130 may be electrically connected to the connection structures 2400. The lower pads 2125 may be connected to the interconnection patterns 2005 of the main substrate 2001 of the electronic system 2000 through conductive connecting portions 2800, as shown in FIG. 2.

Each of the semiconductor chips 2200 may include a semiconductor substrate 3010 and first and second structures 3100 and 3200, which are sequentially stacked on the semiconductor substrate 3010. The first structure 3100 may include a peripheral circuit region, in which peripheral lines 3110 are provided. The second structure 3200 may include a source structure 3205, the stack 3210 on the source structure 3205, the vertical structures 3220 and separation structures penetrating the stack 3210, bit lines 3240 electrically connected to the vertical structures 3220, and cell contact plugs 3235 electrically connected to the word lines WL (e.g., of FIG. 1) of the stack 3210. The second structure 3200 may further include a metal structure to be described below.

Each of the semiconductor chips 2200 may include penetration lines 3245, which are electrically connected to the peripheral lines 3110 of the first structure 3100 and extend into the second structure 3200. The penetration line 3245 may be outside the stack 3210, and in an embodiment, the penetration line 3245 may further penetrate the stack 3210. Each of the semiconductor chips 2200 may further include the input/output pads 2210 (e.g., of FIG. 2), which are electrically connected to the peripheral lines 3110 of the first structure 3100.

Referring to FIG. 4, in the semiconductor package 2003A, each of the semiconductor chips 2200a may include a semiconductor substrate 4010, a first structure 4100 on the semiconductor substrate 4010, and a second structure 4200 on the first structure 4100 and bonded with the first structure 4100 in a wafer bonding manner.

The first structure 4100 may include a peripheral circuit region, in which a peripheral line 4110 and first junction structures 4150 are provided. The second structure 4200 may include a source structure 4205, a stack 4210 between the source structure 4205 and the first structure 4100, vertical structures 4220 and a separation structure 4230 penetrating the stack 4210, and second junction structures 4250, which are respectively and electrically connected to the vertical structures 4220 and the word lines WL (e.g., of FIG. 1) of the stack 4210. In an implementation, the second junction structures 4250 may be electrically and respectively connected to the vertical structures 4220 and the word lines WL (e.g., of FIG. 1) through bit lines 4240, which are electrically connected to the vertical structures 4220, and cell contact plugs 4235, which are electrically connected to the word lines WL (e.g., of FIG. 1). The first junction structures 4150 of the first structure 4100 may be in contact with and coupled to the second junction structures 4250 of the second structure 4200. The coupled portions of the first junction structures 4150 and the second junction structures 4250 may be formed of or include, e.g., copper (Cu).

Each of the first and second structures 4100 and 4200 and the semiconductor chips 2200a may further include a metal structure, as will be described below with reference to an embodiment. Each of the semiconductor chips 2200a may further include the input/output pads 2210 (e.g., of FIG. 2), which are electrically connected to the peripheral lines 4110 of the first structure 4100.

The semiconductor chips 2200 or 2200a of FIG. 3 or 4 may be electrically connected to each other by the connection structures 2400, which may be in the form of bonding wires. In an implementation, semiconductor chips, which may be in the same semiconductor package as the semiconductor chips 2200 or 2200a of FIG. 3 or 4, may be electrically connected to each other by a connection structure including through silicon vias (TSVs).

The first structure 3100 or 4100 of FIG. 3 or 4 may correspond to a peripheral circuit structure in an embodiment to be described below, the second structure 3200 or 4200 of FIG. 3 or 4 may correspond to a cell array structure in an embodiment to be described below.

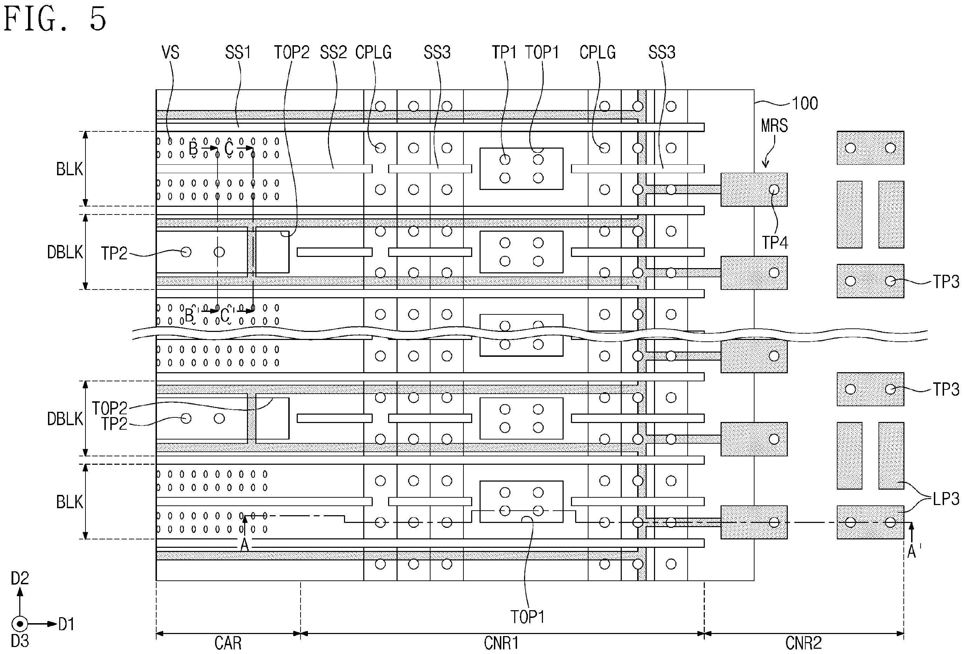

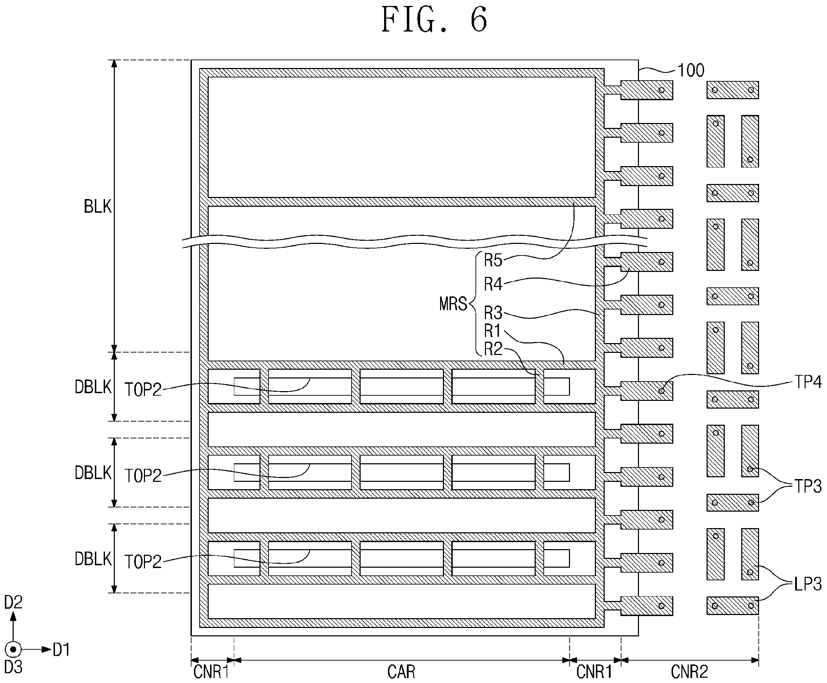

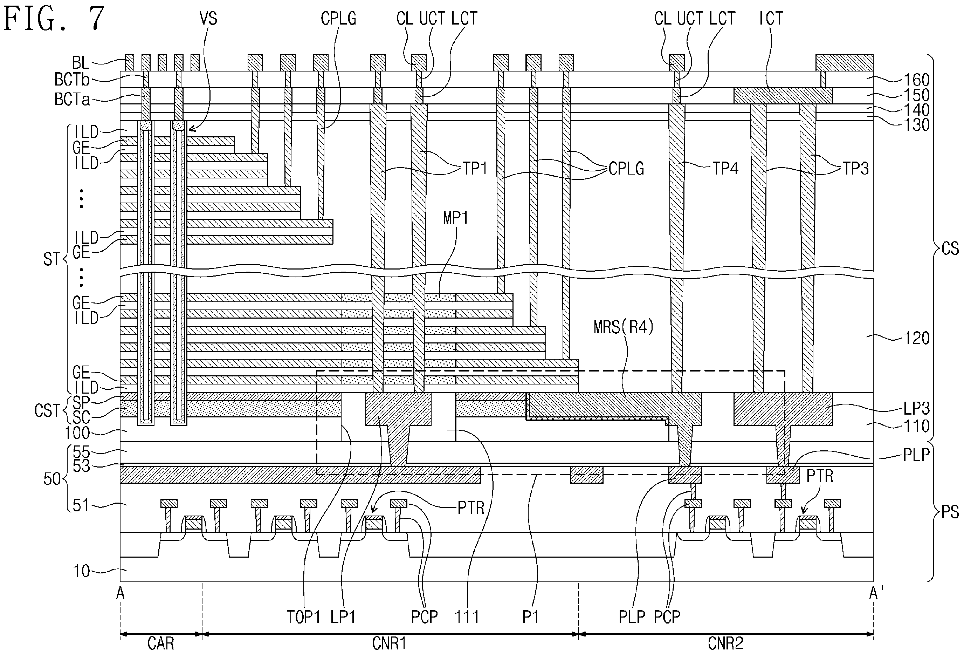

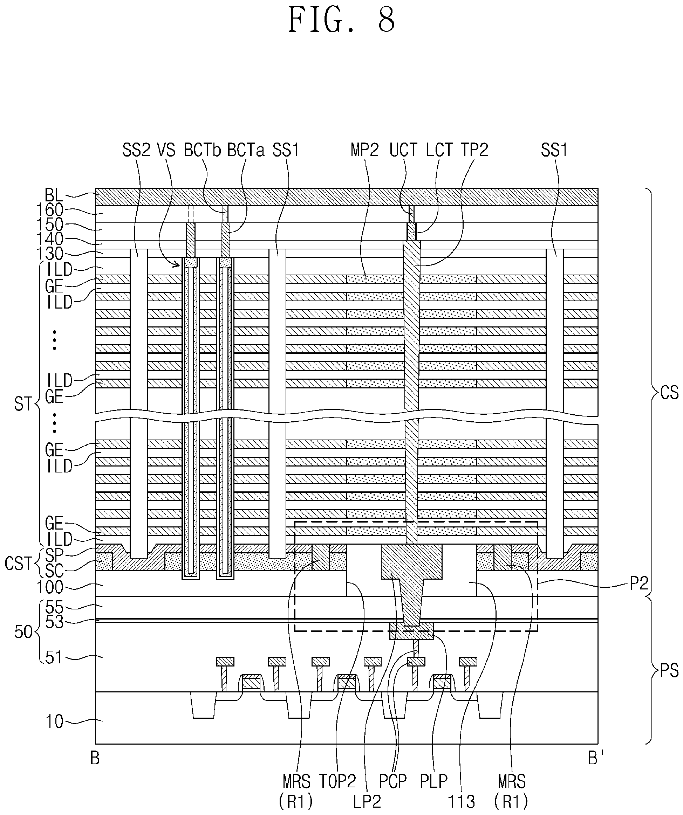

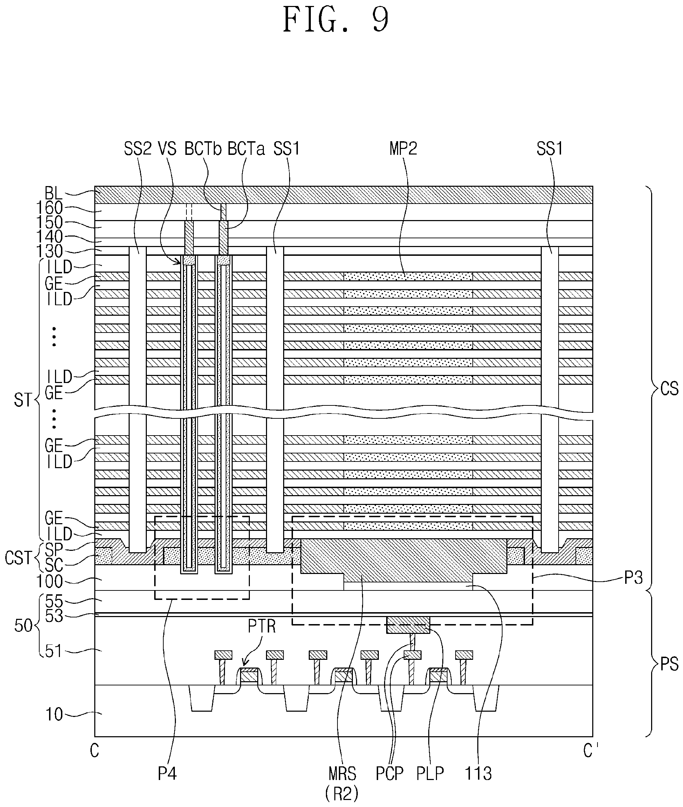

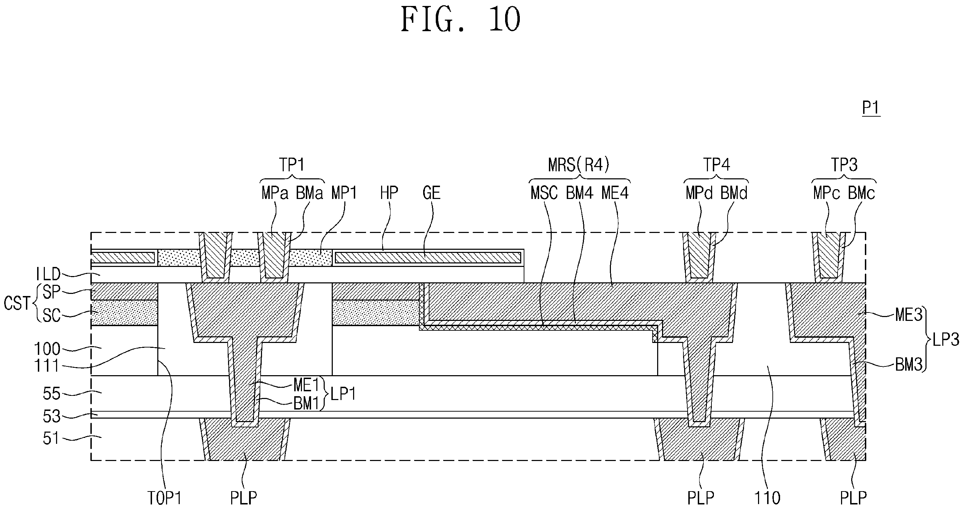

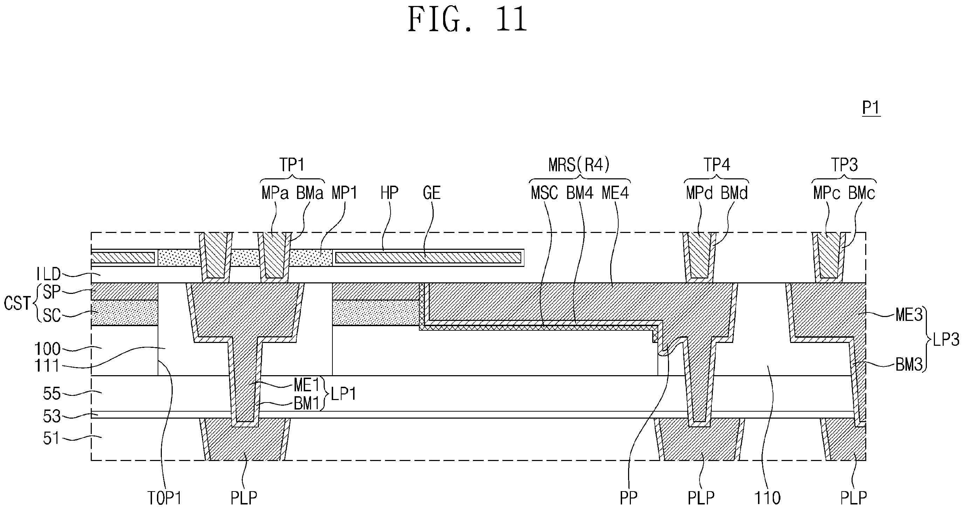

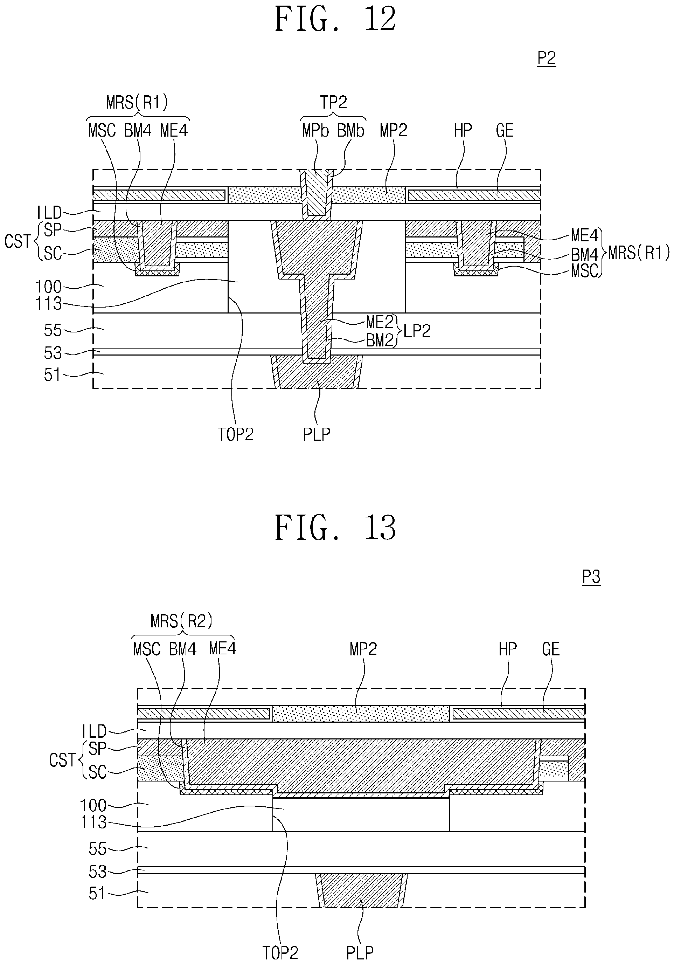

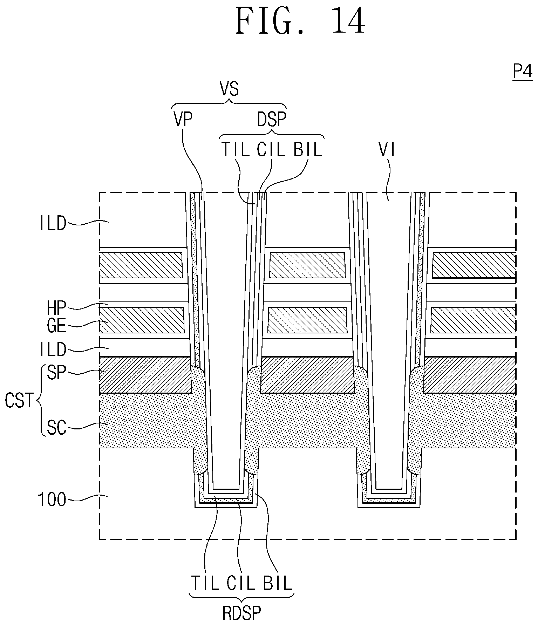

FIG. 5 is a plan view of a semiconductor device according to an embodiment. FIG. 6 is a plan view of a semiconductor layer, a metal structure, and pad patterns of a semiconductor device according to an embodiment. FIGS. 7, 8, and 9 are sectional views, which are taken along lines A-A', B-B', and C-C' of FIG. 5 of a semiconductor device according to an embodiment. FIGS. 10 and 11 are enlarged sectional views of a portion P1 of FIG. 7, FIG. 12 is an enlarged sectional view of a portion P2 of FIG. 8, FIG. 13 is an enlarged sectional view of a portion P3 of FIG. 9, and FIG. 14 is an enlarged sectional view of a portion P4 of FIG. 9.

Referring to FIGS. 5, 7, 8, and 9, a semiconductor device according to an embodiment may include a peripheral circuit structure PS and a cell array structure CS on the peripheral circuit structure PS.

The peripheral circuit structure PS may include peripheral circuits PTR integrated on a top surface of a semiconductor substrate 10, and a lower insulating layer 50 covering the peripheral circuits PTR.

The semiconductor substrate 10 may include a cell array region CAR and first and second connection regions CNR1 and CNR2. In an implementation, the first connection region CNR1 may be between the cell array region CAR and the second connection region CNR2 in a first direction D1. The semiconductor substrate 10 may be a silicon substrate.

The peripheral circuits PTR may include row and column decoders, a page buffer, a control circuit, and so forth. In an implementation, the peripheral circuits PTR may include NMOS and PMOS transistors. Peripheral circuit interconnection lines may be electrically connected to the peripheral circuits PTR through peripheral contact plugs.

The lower insulating layer 50 may be on the top surface of the semiconductor substrate 10. On the semiconductor substrate 10, the lower insulating layer 50 may cover the peripheral circuits PTR, the peripheral contact plugs, the peripheral circuit interconnection lines, and landing pads PLP. The peripheral contact plugs, the peripheral circuit interconnection lines, and the landing pads PLP may be electrically connected to the peripheral circuits PTR.

The lower insulating layer 50 may include a plurality of vertically-stacked insulating layers. In an implementation, the lower insulating layer 50 may include a silicon oxide layer, a silicon nitride layer, a silicon oxynitride layer, or a low-k dielectric layer. In an implementation, the lower insulating layer 50 may include a first lower insulating layer 51, a second lower insulating layer 55, and an etch stop layer 53 between the first and second lower insulating layers 51 and 55. The etch stop layer 53 may be formed of or include an insulating material different from the first and second lower insulating layers 51 and 55 and may cover top surfaces of the landing pads PLP. As used herein, the term "or" is not an exclusive term, e.g., "A or B" would include A, B, or A and B (e.g. any one or more of A and B).

The cell array structure CS may be on the lower insulating layer 50. The cell array structure CS may include a semiconductor layer 100, a metal structure MRS, a source structure CST, a stack ST, vertical structures VS, cell contact plugs CPLG, penetration plugs TP1-TP4, bit lines BL, and conductive lines CL. In an implementation, the cell strings CSTR (e.g., of FIG. 1) may be integrated on the semiconductor layer 100. The stack ST and the vertical structures VS may constitute the cell strings CSTR (e.g., of FIG. 1).

The semiconductor layer 100 may be on a top surface of the lower insulating layer 50. The semiconductor layer 100 may be formed of a semiconductor material, an insulating material, or a conductive material. The semiconductor layer 100 may be formed of or include a doped semiconductor material of the first conductivity type (e.g., n-type) or an undoped or intrinsic semiconductor material. The semiconductor layer 100 may be formed to have one of polycrystalline, amorphous, and single-crystalline structures.

The source structure CST may include a source conductive pattern SC and a conductive support pattern SP on the source conductive pattern SC. The source structure CST may be parallel to a top surface of the semiconductor layer 100 and, in the cell array region CAR, the source structure CST may be extended parallel to the stack ST or in the first direction D1.

The source conductive pattern SC may be formed of or include a semiconductor material, which is doped with dopants (e.g., phosphorus (P) or arsenic (As)) of a first conductivity type. In an implementation, the source conductive pattern SC may be formed of or include a semiconductor layer that is doped with n-type dopants.

The conductive support pattern SP may cover a top surface of the source conductive pattern SC and may be formed of or include a doped semiconductor material of the first conductivity type (e.g., n-type) and/or an undoped or intrinsic semiconductor material. On the cell array region CAR, portions of the conductive support pattern SP may penetrate the source conductive pattern SC to be in contact with the semiconductor layer 100.

An insulating gapfill layer 110 may cover a side surface of the semiconductor layer 100 and a side surface of the source structure CST, on the second connection region CNR2. The insulating gapfill layer 110 may have a top surface that is substantially coplanar with the top surface of the source structure CST.

A first insulating pattern 111 may be on the first connection region CNR1 and in a first penetration hole TOP1, which may penetrate the source structure CST and the semiconductor layer 100. A second insulating pattern 113 may be on the cell array region CAR and in a second penetration hole TOP2, which may penetrate the source structure CST and the semiconductor layer 100. The second insulating pattern 113 may extend in the first direction D1. Each of the first and second insulating patterns 111 and 113 may have a top surface, which is substantially coplanar with the top surface of the source structure CST.

The stack ST may include electrodes GE and insulating layers ILD, which are alternately stacked in a third direction D3 (i.e., a vertical direction), and here, the third direction D3 may be perpendicular to first and second directions D1 and D2 crossing each other. The electrodes GE may be formed of or include, e.g., doped semiconductors (e.g., doped silicon or the like), metals (e.g., tungsten, copper, aluminum, or the like), conductive metal nitrides (e.g., titanium nitride, tantalum nitride, or the like), or transition metals (e.g., titanium, tantalum, or the like). The insulating layers ILD may be formed of or include a silicon oxide layer or a low-k dielectric layer. In an implementation, the semiconductor device may be a vertical-type NAND FLASH memory device, and in this case, the electrodes GE of the stack ST may be used as the gate lower lines LL1 and LL2, the word lines WL, and the gate upper lines UL1 and UL2 described with reference to FIG. 1.

Each of the electrodes GE may include a pad portion on the first connection region CNR1. In an implementation, among the electrodes GE of the stack ST, the pad portions of the 4n-th the electrodes GE may be arranged along the first direction D1, where n is a positive integer. The side surfaces of the (4n-1)-th, (4n-2)-th, and (4n-3)-th electrodes GE may be aligned to the side surface of the 4n-th electrode GE. The cell contact plugs CPLG may be coupled to the pad portions of the 4n-th the electrodes GE. In an implementation, among of the electrodes GE of the stack ST, the pad portions of even- or odd-numbered electrodes GE may be disposed along the first direction D1, and the cell contact plugs CPLG may be respectively coupled to the pad portions of the even-numbered electrodes GE. In an implementation, the pad portions of the electrodes GE may be located at positions that are different from each other in both of horizontal and vertical directions.

In an implementation, on the first connection region CNR1, the stack ST may include first mold patterns MP1, each of which is located at the same level as a corresponding one of the electrodes GE and is between the insulating layers ILD. The first mold patterns MP1 may be between portions of the electrodes GE on the cell array region CAR and the pad portions of the electrodes GE. Furthermore, the first mold patterns MP1 may be overlapped with the first insulating pattern 111, when viewed in a plan view. In an implementation, on the cell array region CAR, the stack ST may include second mold patterns MP2, each of which is located at the same level as a corresponding one of the electrodes GE and is between the insulating layers ILD. The second mold patterns MP2 may extend in the first direction D1 and may overlap with the second insulating pattern 113. The first and second mold patterns MP1 and MP2 may be formed of or include an insulating material having an etch selectivity with respect to the insulating layers ILD.

On the cell array region CAR, the vertical structures VS may penetrate the stack ST. Each of the vertical structures VS may include a lower vertical structure and an upper vertical structure, which may penetrate a lower region and an upper region, respectively, of the stack ST.

Referring to FIG. 14, each of the vertical structures VS may include a vertical semiconductor pattern VP and a data storage pattern DSP enclosing a side surface of the vertical semiconductor pattern VP. In an implementation, the vertical semiconductor pattern VP may have a pipe or macaroni (e.g., hollow cylindrical) shape with closed bottom and open top. The vertical semiconductor pattern VP may have a 'U'-shaped section and an internal space of the vertical semiconductor pattern VP may be filled with an insulating material. The vertical semiconductor pattern VP may be formed of or include a semiconductor material (e.g., silicon (Si) or germanium (Ge)). The vertical semiconductor pattern VP, which may be formed of or includes a semiconductor material, may be used as channel regions of the upper transistors UT1 and UT2, the memory cell transistors MCT, and the lower transistors LT1 and LT2 described with reference to FIG. 1.

The data storage pattern DSP may be extended in the third direction D3 to enclose the side surface of the vertical semiconductor pattern VP. The data storage pattern DSP may be a pipe- or macaroni-shaped pattern with open top and bottom. The data storage pattern DSP may be composed of one or more layers. In an implementation, the data storage pattern DSP may be a data storing layer of a NAND FLASH memory device and may include a tunnel insulating layer TIL, a charge storing layer CIL, and a blocking insulating layer BIL, which may be sequentially stacked on the side surface of the vertical semiconductor pattern VP. In an implementation, the charge storing layer CIL may be a trap insulating layer, a floating gate electrode, or an insulating layer with conductive nanodots. In addition, a dummy data storage pattern RDSP may be in the semiconductor layer 100 to be spaced apart from the data storage pattern DSP. The dummy data storage pattern RDSP may have the same layer structure as the data storage pattern DSP.

A horizontal insulating pattern HP may be between side surfaces of the electrodes GE and the data storage pattern DSP. The horizontal insulating pattern HP may be extended from the side surfaces of the electrodes GE to cover top and bottom surfaces of the electrodes GE.

The vertical semiconductor pattern VP of each vertical structure VS may have a side surface that is in partial contact with the source conductive pattern SC. In each vertical structure VS, a bottom surface of the data storage pattern DSP may be located at a level that is lower than a bottom surface of the lowermost electrode GE but is higher than the top surface of the source conductive pattern SC.

Referring back to FIGS. 5, 7, 8, and 9, a planarization insulating layer 120 may cover the stepwise pad portions of the stack ST. The planarization insulating layer 120 may have a substantially flat top surface. The planarization insulating layer 120 may include a single insulating layer or a plurality of stacked insulating layers. First to fourth interlayer insulating layers 130, 140, 150, and 160 may be sequentially stacked on the planarization insulating layer 120.

First and second separation structures SS1 and SS2 may be on the semiconductor layer 100 to penetrate the stack ST. The first separation structures SS1 may extend (e.g., lengthwise) in the first direction D1 from the cell array region CAR to the first connection region CNR1 and may be spaced apart from each other in the second direction D2 crossing the first direction D1. The second separation structure SS2 may be on the cell array region CAR to penetrate the stack ST. The second separation structure SS2 may be between the first separation structures SS1. A length of the second separation structure SS2 in the first direction D1 may be smaller than that of the first separation structure SS1. In an implementation, a plurality of the second separation structures SS2 may be between the first separation structures SS1. Each of the first and second separation structures SS1 and SS2 may include an insulating layer covering a side surface of the stack ST.

Third separation structures SS3 may be on the first connection region CNR1 to be spaced apart from the first and second separation structures SS1 and SS2 and to penetrate the planarization insulating layer 120 and the stack ST. The third separation structures SS3 may extend in the first direction D1.

In the cell array region CAR, a memory block BLK may be defined between each adjacent pair of the first separation structures SS1. The memory block BLK may be composed of the stack ST and the vertical structures VS. A plurality of the memory blocks BLK may be arranged in the second direction D2. A dummy memory block DBLK may be between a pair of memory blocks BLK, which are adjacent to each other in the second direction D2. Similar to the memory block BLK, the dummy memory block DBLK may include the stack ST and the vertical structures VS, but the stack ST of the dummy memory block DBLK may be configured to include the second mold patterns MP2 on the cell array region CAR.

In an implementation, a first pad pattern LP1 may be in the first insulating pattern 111 and may be electrically connected to the landing pad PLP of the peripheral circuit structure PS. A second pad pattern LP2 may be in the second insulating pattern 113 and may be connected to the landing pad PLP of the peripheral circuit structure PS. A third pad pattern LP3 may be in the insulating gap fill layer 110 and spaced apart from the stack ST and the semiconductor layer 100. The third pad pattern LP3 may be electrically connected to the landing pad PLP of the peripheral circuit structure PS.

In an implementation, referring to FIG. 10, the first pad pattern LP1 may include a via portion, which vertically penetrates the first insulating pattern 111, the second lower insulating layer 55, and the etch stop layer 53 and is coupled to the landing pad PLP, and a pad portion, which is in the first insulating pattern 111 and is connected to the via portion. The first pad pattern LP1 may include a first metal pattern ME1 and a first barrier metal pattern BM1, which may cover or enclose side and bottom surfaces of the first metal pattern ME1.

Referring to FIG. 12, the second pad pattern LP2 may include a via portion, which may vertically penetrate the second insulating pattern 113, the second lower insulating layer 55, and the etch stop layer 53 and coupled to the landing pad PLP, and a pad portion, which may be in the second insulating pattern 113 and connected to the via portion. The second pad pattern LP2 may include a second metal pattern ME2 and a second barrier metal pattern BM2, which may cover or enclose side and bottom surfaces of the second metal pattern ME2.

Referring back to FIG. 10, the third pad pattern LP3 may include a via portion, which may vertically penetrate the insulating gapfill layer 110, the second lower insulating layer 55, and the etch stop layer 53 and may be coupled to the landing pad PLP, and a pad portion, which may be in the insulating gapfill layer 110 and connected to the via portion. The third pad pattern LP3 may include a third metal pattern ME3 and a third barrier metal pattern BM3, which may cover or enclose side and bottom surfaces of the third metal pattern ME3.

The first, second, and third pad patterns LP1, LP2, and LP3 may have top surfaces (e.g., surfaces facing away from the semiconductor substrate 10) that are located at substantially the same level (e.g., coplanar or the same distance from the semiconductor substrate 10). In an implementation, the top surfaces of the first, second, and third pad patterns LP1, LP2, and LP3 may be substantially coplanar with the top surface of the conductive support pattern SP.

The first, second, third barrier metal patterns BM1, BM2, and BM3 may be formed of or include the same metal material, and the first, second, and third metal patterns ME1, ME2, and ME3 may be formed of or include the same metal material. The first, second, third barrier metal patterns BM1, BM2, and BM3 may include a titanium layer, a titanium nitride layer, a tantalum layer, a tantalum nitride layer, a ruthenium layer, a cobalt layer, a manganese layer, a tungsten nitride layer, a nickel layer, a nickel boride layer, or a double layer of titanium/titanium nitride, or a mixed (but not double) layer. The first, second, and third metal patterns ME1, ME2, and ME3 may be formed of or include titanium, tantalum, ruthenium, cobalt, manganese, tungsten, nickel, or copper.

Referring to FIGS. 5, 6, 7, 8, and 9, the metal structure MRS may be between the semiconductor layer 100 and the source structure CST and may be in contact with a portion of the semiconductor layer 100.

The metal structure MRS may include first portions R1 in the cell array region CAR and the first connection region CNR1 and extending (e.g., lengthwise) in the first direction D1, and second portions R2 and R3 connected to the first portions R1 and extending (e.g., lengthwise) in the second direction D2 crossing the first direction D1. In an implementation, the second portions R2 and R3 may include a first region R2 connected to each adjacent pair of the first portions R1 in the cell array region CAR and crossing the second insulating pattern 113, and a second region R3 connecting the first portions R1 to each other in the first connection region CNR1. The first and second portions R1, R2, and R3 of the metal structure MRS may overlap with the stack ST, when viewed in a plan view (e.g., along the third direction D3).

In an implementation, the metal structure MRS may further include pad portions R4 extending from the second region R3 of the second portion in the first direction D1. In an implementation, the metal structure MRS may further include at least one fifth portion R5 extending in the first direction D1 below the memory block BLK.

In an implementation, the metal structure MRS may include a via portion vertically extending from at least one of the first and second portions R1, R2, and R3 and connected to the landing pad PLP. In an implementation, the via portion of the metal structure MRS may be laterally spaced apart from the semiconductor layer 100 and may vertically extend from the pad portion R4 of the metal structure MRS.

In an implementation, referring to FIGS. 10, 12, and 13, the metal structure MRS may have a substantially flat top surface. In an implementation, the top surface of the metal structure MRS may be located at substantially the same level as the top surface of the source structure CST (e.g., the top surface of the conductive support pattern SP). In an implementation, the top surface of the metal structure MRS may be substantially coplanar with the top surfaces of the first to third pad patterns LP1, LP2, and LP3.

The metal structure MRS may have a side surface that is in contact with the source structure CST. Portions of the metal structure MRS may be in direct contact with the insulating gapfill layer 110 and the second insulating pattern 113. The metal structure MRS may have a first thickness (e.g., in the third direction D3) on the semiconductor layer 100 and may have a second thickness, which is larger than the first thickness, on the insulating gapfill layer 110 and the second insulating pattern 113.

Referring to FIG. 11, the metal structure MRS may have a protruding portion PP, at a region where the insulating gapfill layer 110 and the semiconductor layer 100 are in contact with each other. The protruding portion PP may have a non-uniform thickness.

Referring to FIGS. 10, 12, and 13, the metal structure MRS may include a fourth barrier metal pattern BM4 and a fourth metal pattern ME4. The fourth barrier metal pattern BM4 may enclose bottom and side surfaces of the fourth metal pattern ME4. In an implementation, the fourth barrier metal pattern BM4 may include a titanium layer, a titanium nitride layer, a tantalum layer, a tantalum nitride layer, a ruthenium layer, a cobalt layer, a manganese layer, a tungsten nitride layer, a nickel layer, a nickel boride layer, or a double layer of titanium/titanium nitride, or a mixed (but not double) layer. The fourth metal pattern ME4 may be formed of or include titanium, tantalum, ruthenium, cobalt, manganese, tungsten, nickel, or copper.

The fourth barrier metal pattern BM4 may be formed of or include the same metal material as the first, second, third barrier metal patterns BM1, BM2, and BM3, and the fourth metal pattern ME4 may be formed of or include the same metal material as the first, second, and third metal patterns ME1, ME2, and ME3.

In an implementation, the metal structure MRS may further include a metal-semiconductor compound layer MSC between the semiconductor layer 100 and a portion of the metal structure MRS and between the source structure CST and the metal structure MRS. In an implementation, a metal silicide layer (e.g., of tungsten silicide, cobalt silicide, or titanium silicide) may be between the semiconductor layer 100 and the metal structure MRS.

In an implementation, the metal structure MRS may help prevent an increase in resistance of the semiconductor layer 100, which could be caused by the first and second insulating patterns 111 and 113 in the semiconductor layer 100, when there is a current flowing through the semiconductor layer 100, and thus, a reduction in operation speed of the device may be prevented. In an implementation, the semiconductor layer 100 and the metal structure MRS may be used as a high-speed current path, between the fourth penetration plugs TP4 and the vertical structures VS.

Referring to FIGS. 5, 7, 8, and 9, the cell contact plugs CPLG may penetrate the first and second interlayer insulating layers 130 and 140 and the planarization insulating layer 120 and may be coupled to the pad portions of the electrodes GE, respectively. The smaller the distance to the cell array region CAR, the smaller the vertical lengths of the cell contact plugs CPLG. The cell contact plugs CPLG may have top surfaces that are substantially coplanar with each other. The conductive lines CL may be on the fourth interlayer insulating layer 160 of the first connection region CNR1 and may be coupled to the cell contact plugs CPLG through lower and upper contact plugs LCT and UCT.

In an implementation, in the structure of FIGS. 7, 8, and 9, the bit lines BL may be on the fourth interlayer insulating layer 160 in the cell array region CAR and may extend in the second direction D2 to cross the stack ST. The bit lines BL may be electrically connected to the vertical structures VS through lower and upper bit line contact plugs BCTa and BCTb.

First penetration plugs TP1 may be in the first connection region CNR1 to vertically penetrate the first mold patterns MP1 of the stack ST and may be connected to the first pad pattern LP1. The first penetration plugs TP1 may be electrically connected to the cell contact plugs CPLG through the conductive lines CL.

Second penetration plugs TP2 may be in the cell array region CAR to vertically penetrate the second mold patterns MP2 of the stack ST and may be connected to the second pad pattern LP2. The second penetration plugs TP2 may be electrically connected to the bit lines BL through the lower and upper contact plugs LCT and UCT.

Third penetration plugs TP3 may be in the second connection region CNR2 to penetrate the planarization insulating layer 120 and may be coupled to the third pad pattern LP3. The third penetration plugs TP3 may be horizontally spaced apart from the stack ST.

The fourth penetration plugs TP4 may be in the second connection region CNR2 to penetrate the planarization insulating layer 120 and may be coupled to the metal structure MRS. The fourth penetration plugs TP4 may be horizontally spaced apart from the stack ST.

The first to fourth penetration plugs TP1, TP2, TP3, and TP4 may have substantially the same vertical length and may be formed of or include the same conductive material. Each of the first to fourth penetration plugs TP1, TP2, TP3, and TP4 may include a barrier metal layer BMa, BMb, BMc, or BMd, which is formed of or includes a conductive metal nitride (e.g., titanium nitride, tantalum nitride, or the like), and a metal layer MPa, MPb, MPc, or MPd, which is formed of or includes a metallic material (e.g., tungsten, titanium, tantalum, or the like).

A connection conductive pattern ICT may be on the second interlayer insulating layer 140 in the second connection region CNR2 and may be connected in common to the third penetration plugs TP3.

In an implementation, the first, second, and third pad patterns LP1, LP2, and LP3 and the metal structure MRS may be at the same level, and it is possible to easily form the first to fourth penetration plugs TP1, TP2, TP3, and TP4 connected thereto.

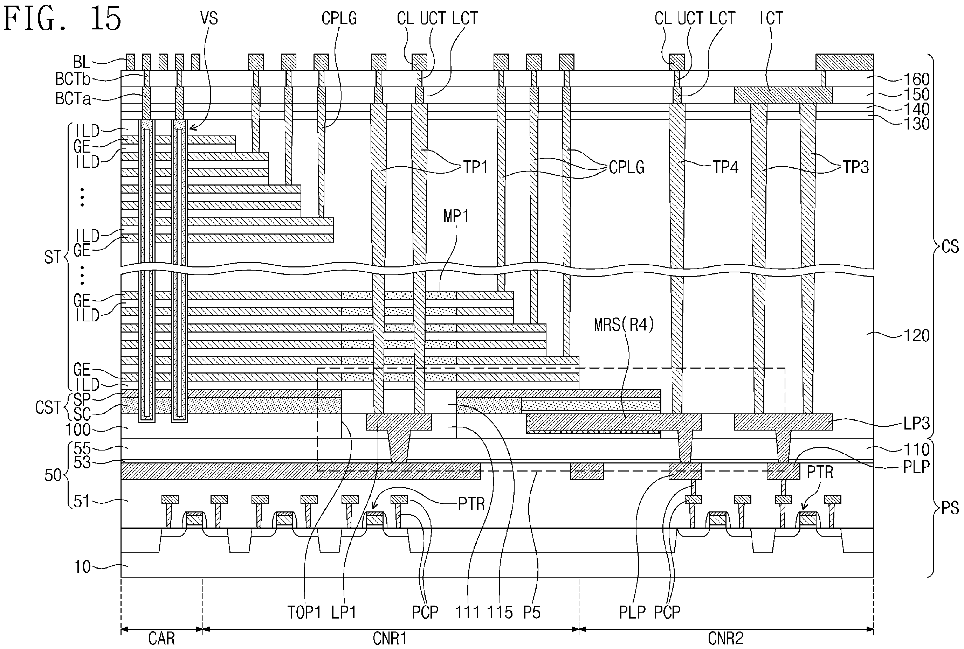

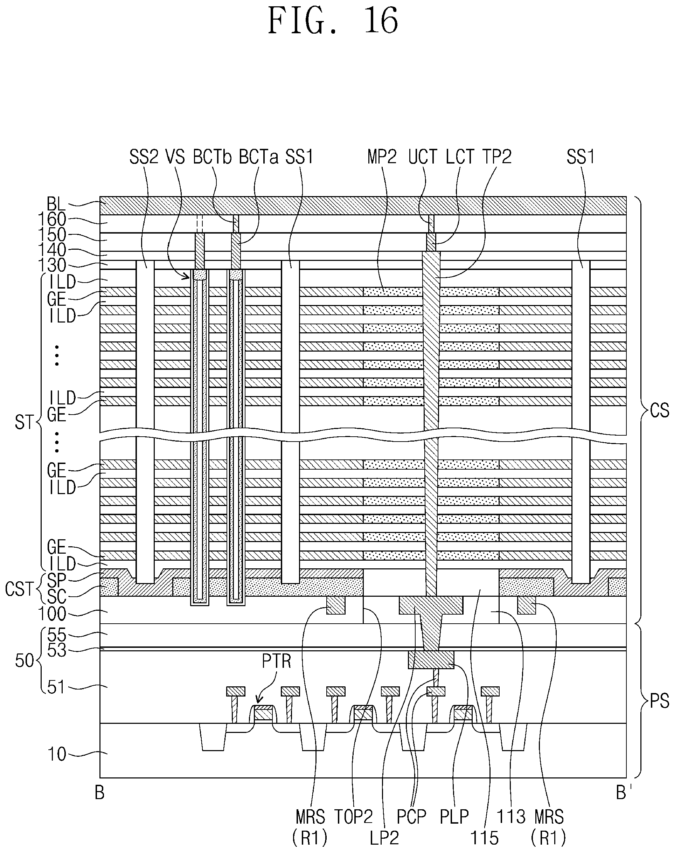

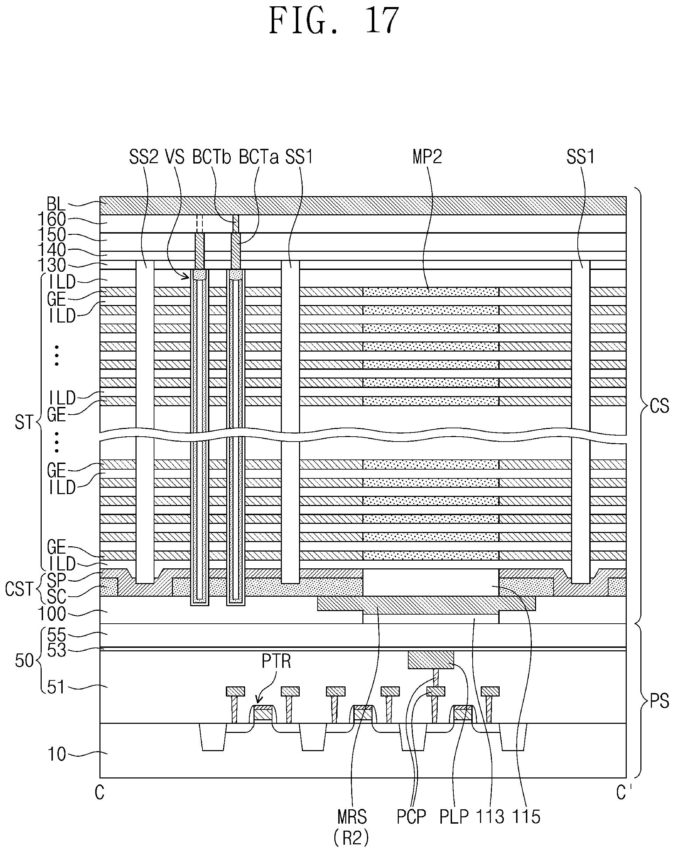

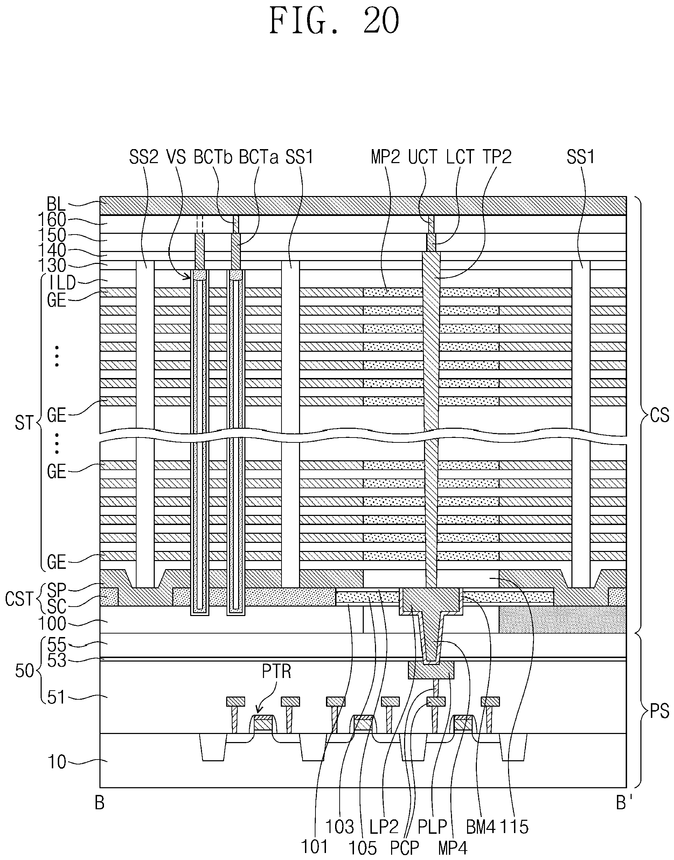

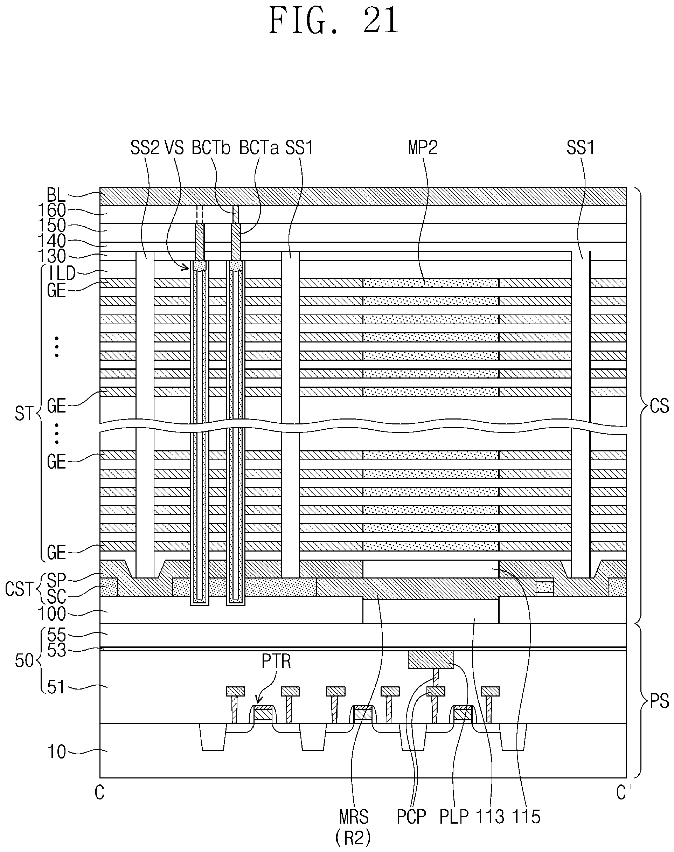

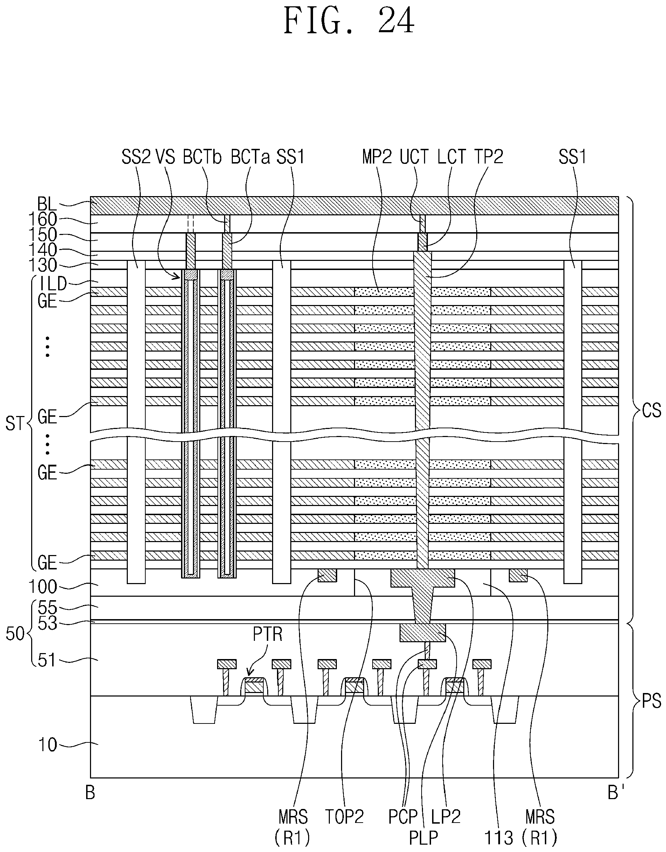

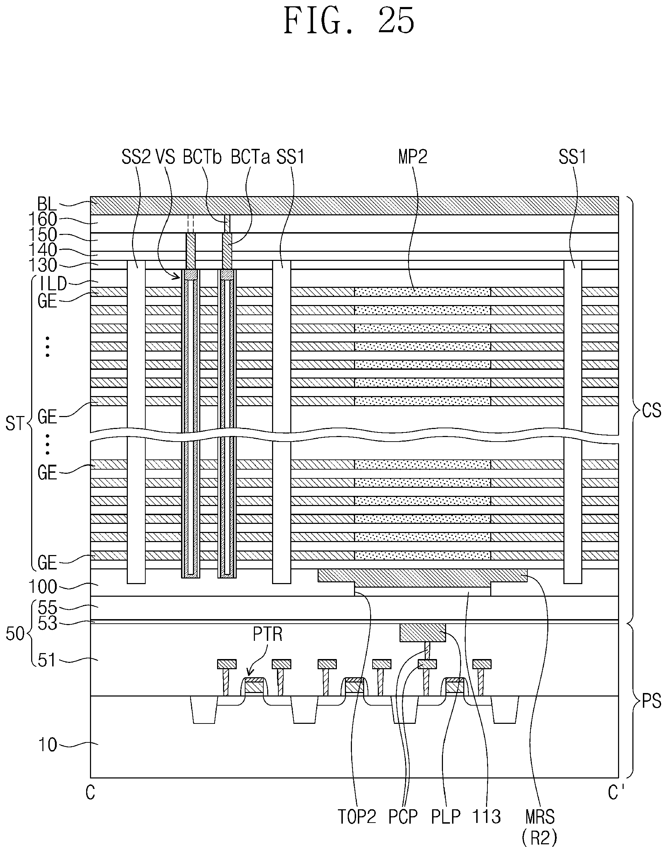

Hereinafter, the semiconductor devices according to some embodiments will be described in more detail with reference to FIGS. 15 to 26. In the following description of FIGS. 15 to 26, a previously described element may be identified by the same reference number without repeating an overlapping description thereof, for the sake of brevity.

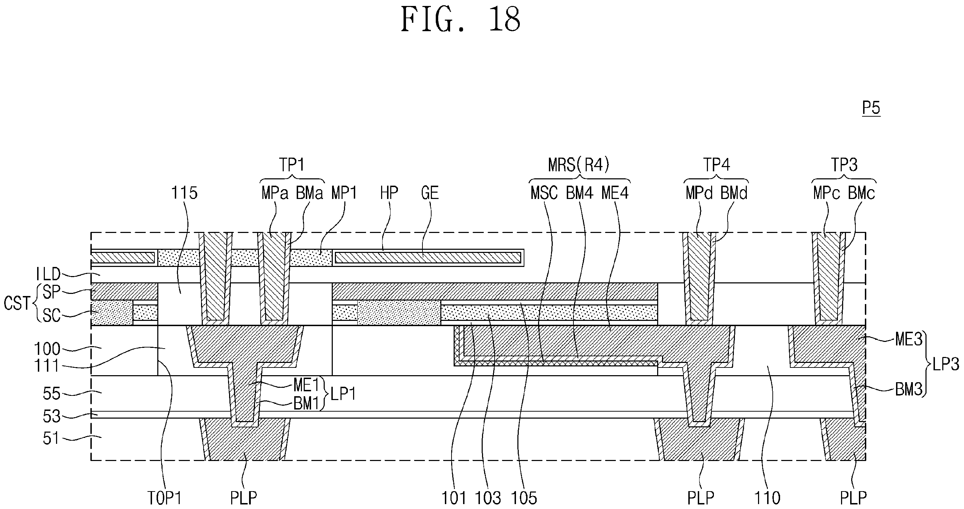

FIGS. 15, 16, and 17 are sectional views, which are taken along the lines A-A', B-B', and C-C' of FIG. 5 to illustrate a semiconductor device according to an embodiment. FIG. 18 is an enlarged sectional view of a portion P5 of FIG. 15.

Referring to FIGS. 15, 16, and 17, the top surfaces of the first, second, and third pad patterns LP1, LP2, and LP3 and the metal structure MRS may be located at substantially the same level as the top surface of the semiconductor layer 100.

The first pad pattern LP1 may be in the first insulating pattern 111, and a third insulating pattern 115 may be on the first insulating pattern 111 to penetrate the source structure CST. The third insulating pattern 115 may cover the top surface of the first pad pattern LP1.

The first penetration plugs TP1 may be on the first connection region CNR1 to penetrate the third and first insulating patterns 115 and 111 and may be coupled to the first pad pattern LP1.

The metal structure MRS may be partially buried in the semiconductor layer 100. The source structure CST may be on a portion of the metal structure MRS.

The source structure CST may further include remaining insulating patterns, which are between the semiconductor layer 100 and the conductive support pattern SP. In an implementation, the remaining insulating patterns may include a first buffer insulating layer 101, a lower sacrificial pattern 103, and a second buffer insulating layer 105, which are sequentially stacked. In an implementation, the lower sacrificial pattern 103 may be formed of or include an insulating material that is different from the first and second buffer insulating layers 101 and 105. The remaining insulating pattern may partially cover the top surface of the metal structure MRS. In an implementation, at least a portion of the top surface of the metal structure MRS may be in direct contact with the first buffer insulating layer 101.

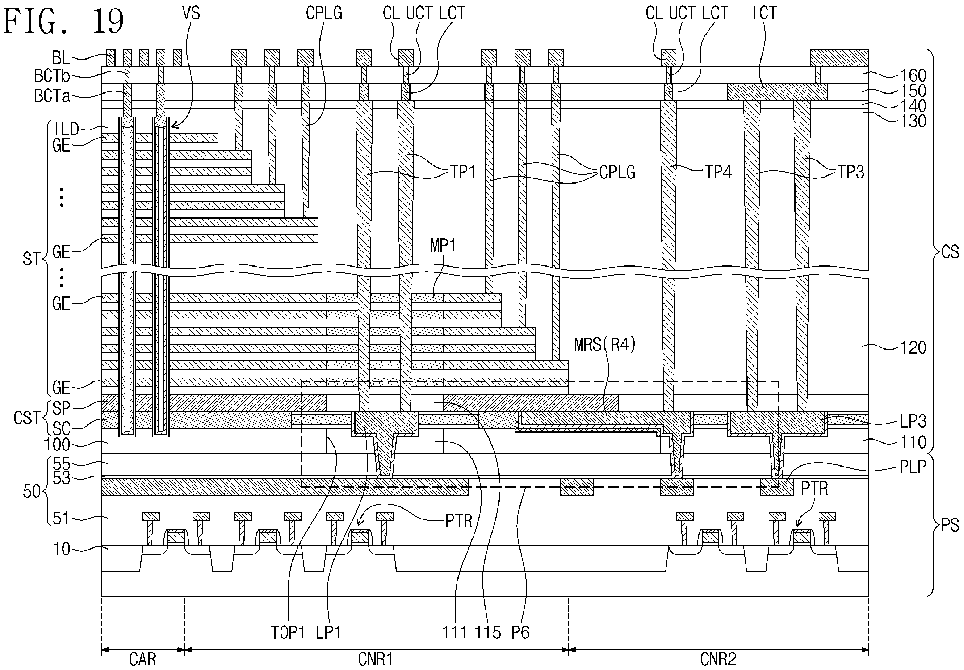

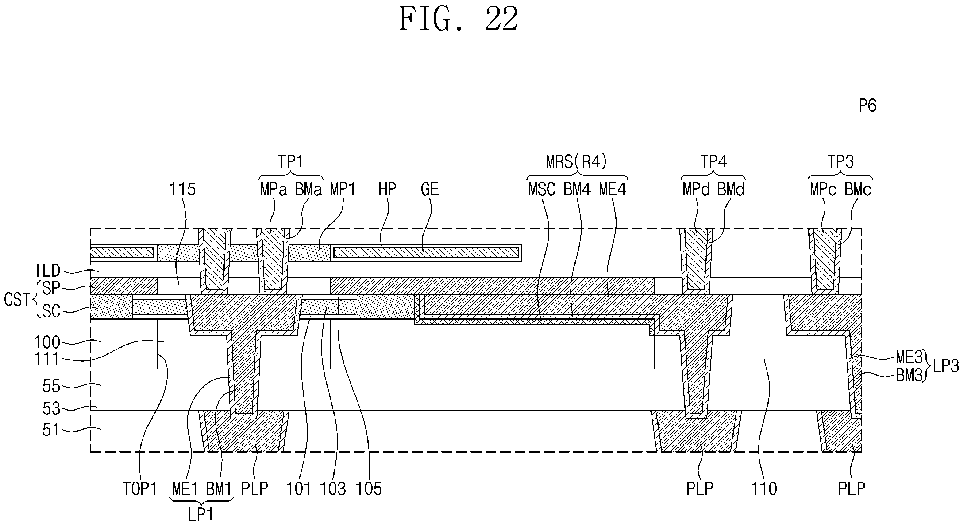

FIGS. 19, 20, and 21 are sectional views, which are taken along the lines A-A', B-B', and C-C' of FIG. 5 to illustrate a semiconductor device according to an embodiment. FIG. 22 is an enlarged sectional view of a portion P6 of FIG. 19.

Referring to FIGS. 19, 20, and 21, the top surfaces of the first, second, and third pad patterns LP1, LP2, and LP3 and the metal structure MRS may be located at substantially the same level as the top surface of the source conductive pattern SC.

At least a portion of the top surface of the metal structure MRS may be in direct contact with the conductive support pattern SP. The third insulating pattern 115 may be on the first insulating pattern 111 to penetrate the conductive support pattern SP.

The source structure CST may further include remaining insulating patterns, which are between the semiconductor layer 100 and the third insulating pattern 115. In an implementation, the remaining insulating patterns may include the first buffer insulating layer 101, the lower sacrificial pattern 103, and the second buffer insulating layer 105, which are sequentially stacked. At least a portion of the remaining insulating patterns may be in contact with a side surface of the second pad pattern LP2, on the cell array region CAR.

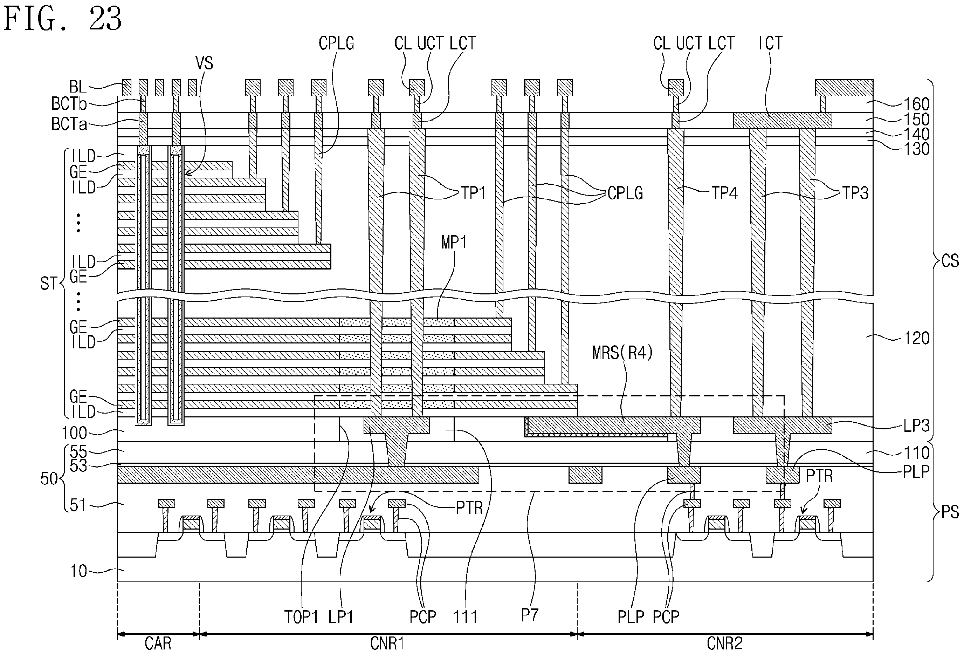

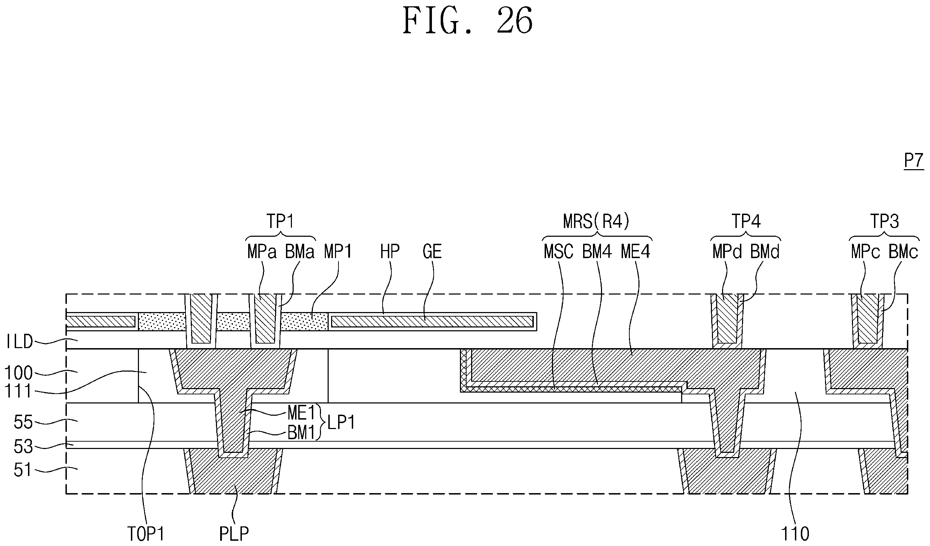

FIGS. 23, 24, and 25 are sectional views, which are taken along the lines A-A', B-B', and C-C' of FIG. 5 to illustrate a semiconductor device according to an embodiment. FIG. 26 is an enlarged sectional view of a portion P7 of FIG. 19.

In the embodiment of FIGS. 23, 24, and 25, the source structure may be omitted, unlike the afore-described embodiments. In the present embodiment, the vertical semiconductor pattern of the vertical structure VS may be in direct contact with the semiconductor layer 100.

The lowermost insulating layer ILD of the stack ST may be disposed on the top surfaces of the first, second, third pad patterns LP1, LP2, and LP3 and the metal structure MRS.

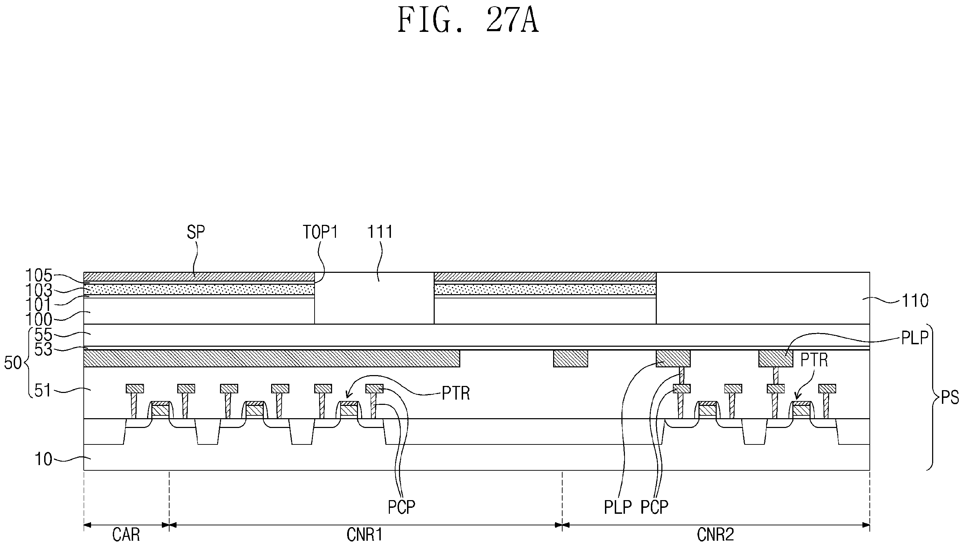

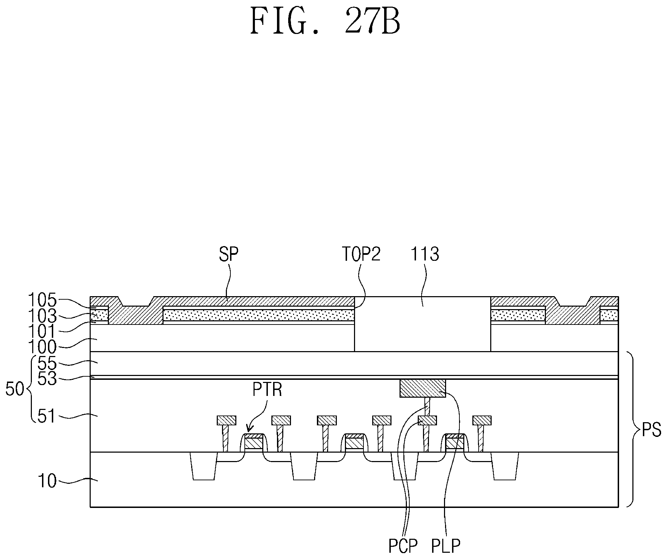

FIGS. 27A to 33A and FIGS. 27B to 33B are sectional views of stages in a method of fabricating a semiconductor device, according to an embodiment.

Referring to FIGS. 5, 27A, and 27B, the peripheral circuit structure PS may be formed on the semiconductor substrate 10.

The formation of the peripheral circuit structure PS may include forming the peripheral circuits PTR on the semiconductor substrate 10, forming peripheral interconnection structures PCP connected to the peripheral circuits PTR, and forming the lower insulating layer 50. Here, the peripheral circuits PTR may include metal oxide semiconductor (MOS) transistors, and in this case, the semiconductor substrate 10 may be used as channel regions of the MOS transistors.

The lower insulating layer 50 may include one or more insulating layers covering the peripheral circuits PTR. The lower insulating layer 50 may include, e.g., a silicon oxide layer, a silicon nitride layer, a silicon oxynitride layer, or a low-k dielectric layer.

The formation of the peripheral interconnection structures PCP may include forming peripheral contact plugs to penetrate portions of the lower insulating layer 50 and forming peripheral circuit interconnection lines connected to the peripheral contact plugs.

Next, the semiconductor layer 100 may be formed by depositing a semiconductor material on the lower insulating layer 50. The semiconductor layer 100 may be formed of or include a semiconductor material (e.g., silicon (Si), germanium (Ge), silicon germanium (SiGe), gallium arsenic (GaAs), indium gallium arsenic (InGaAs), aluminum gallium arsenic (AlGaAs), or compounds thereof). The semiconductor layer 100 may be formed of or include a doped semiconductor material or an undoped or intrinsic semiconductor material. The semiconductor layer 100 may be formed to have polycrystalline, amorphous, or single-crystalline structures.

A first buffer insulating layer 101, a lower sacrificial layer 103, and a second buffer insulating layer 105 may be sequentially stacked on the semiconductor layer 100. The first buffer insulating layer 101 may be formed by performing a thermal oxidation process on a surface of the semiconductor layer 100 or by depositing a silicon oxide layer. The lower sacrificial layer 103 may be formed of a material having an etch selectivity with respect to the first buffer insulating layer 101. In an implementation, the lower sacrificial layer 103 may be a silicon nitride layer, a silicon oxynitride layer, a silicon carbide layer, or a silicon germanium layer. The second buffer insulating layer 105 may be formed by depositing a silicon oxide layer.

The first buffer insulating layer 101, the lower sacrificial layer 103, the second buffer insulating layer 105 may be formed to have openings exposing portions of the semiconductor layer 100, on the cell array region CAR. After the formation of the openings, a conductive support layer SP may be formed on the second buffer insulating layer 105 to have a constant thickness. On the cell array region CAR, the conductive support layer SP may fill the openings of the first buffer insulating layer 101, the lower sacrificial layer 103, and the second buffer insulating layer 105. In the openings, the conductive support layer SP may be in direct contact with the semiconductor layer 100. The conductive support layer SP may be a poly-silicon layer, which is doped with n-type dopants or carbon (C).

Next, the conductive support layer SP, the second buffer insulating layer 105, the lower sacrificial layer 103, the first buffer insulating layer 101, and the semiconductor layer 100 may be patterned to expose portions of the lower insulating layer 50. Accordingly, the first penetration holes TOP1 may be formed on the first connection region CNR1, and the second penetration hole TOP2 may be formed on the cell array region CAR.

Thereafter, the first and second insulating patterns 111 and 113 may be formed to fill the first and second penetration holes TOP1 and TOP2, respectively, and then, the insulating gapfill layer 110 may be formed to cover side surfaces of the semiconductor layer 100, the first buffer insulating layer 101, the lower sacrificial layer 103, the second buffer insulating layer 105, and the conductive support layer SP. In an implementation, an intermediate insulating layer may include the first and second insulating patterns 111 and 113 and the insulating gapfill layer 110.

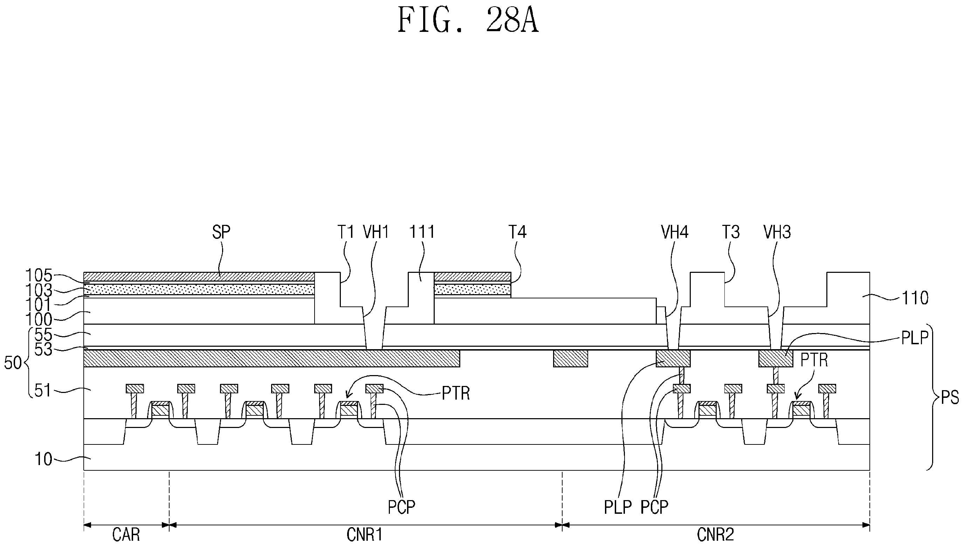

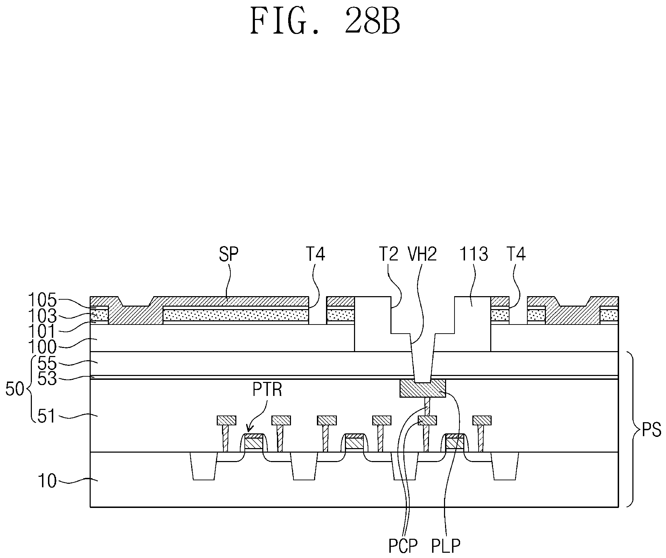

Referring to FIGS. 5, 28A, and 28B, via holes VH1, VH2, VH3, and VH4 may be formed to expose the landing pads PLP of the peripheral circuit structure PS, and trenches T1, T2, T3, and T4 may be formed to be connected to the via holes VH1, VH2, VH3, and VH4. Each of the via holes VH1, VH2, VH3, and VH4 may vertically penetrate a portion of the semiconductor layer 100 and a portion of the lower insulating layer 50, and the trenches T1, T2, T3, and T4 may be partially formed in the first and second insulating patterns 111 and 113 and the insulating gapfill layer 110.

In an implementation, the formation of the via holes and the trenches may include forming a mask pattern, etching the first and second insulating patterns 111 and 113 and the insulating gapfill layer 110 using the mask pattern as an etch mask to form the first, second, third, and fourth trenches T1, T2, T3, and T4, filling the first, second, third, and fourth trenches T1, T2, T3, and T4 with sacrificial layers, and etching not only the sacrificial layers in the first, second, third, and fourth trenches T1, T2, T3, and T4 but also the first and second insulating patterns 111 and 113, the insulating gapfill layer 110, and the lower insulating layer 50 to form the first, second, third, and fourth via holes VH1, VH2, VH3, and VH4. In an implementation, the first, second, third, and fourth via holes VH1, VH2, VH3, and VH4 may be first formed, and then, the first, second, third, and fourth trenches T1, T2, T3, and T4 may be formed.

The first via hole VH1 may be formed to penetrate the first insulating pattern 111 and the lower insulating layer 50 thereunder and to expose the landing pads PLP of the peripheral circuit structure PS, and the first trench T1 may be connected to the first via hole VH1, in the first insulating pattern 111. A bottom surface of the first trench T1 may be spaced apart from a bottom surface of the semiconductor layer 100.

The second via hole VH2 may be formed to penetrate the second insulating pattern 113 and the lower insulating layer 50 thereunder and to expose the landing pads PLP of the peripheral circuit structure PS, and the second trench T2 may be connected to the second via hole VH2, in the second insulating pattern 113. A bottom surface of the second trench T2 may be spaced apart from the bottom surface of the semiconductor layer 100.

The third via hole VH3 may be formed to penetrate the insulating gapfill layer 110 and the lower insulating layer 50 thereunder and to expose the landing pads PLP of the peripheral circuit structure PS, and the third trench T3 may be connected to the third via hole VH3, in the insulating gapfill layer 110.

The fourth via hole VH4 may be formed to penetrate the insulating gapfill layer 110 and the lower insulating layer 50 thereunder and to expose the landing pads PLP of the peripheral circuit structure PS, and the fourth trench T4 may be formed to penetrate the semiconductor layer 100 and may be connected to the fourth via hole VH4, in the insulating gapfill layer 110. The formation of the fourth trench T4 may include sequentially etching portions of the conductive support layer SP, the second buffer insulating layer 105, the lower sacrificial layer 103, and the first buffer insulating layer 101. In an implementation, during the formation of the fourth trench T4, the insulating gapfill layer 110 may be partially etched, and a dent may be formed near the semiconductor layer 100.

The fourth trench T4 may include the first parts, which are provided in the cell array region CAR and are extended in the first direction D1, and the second parts, which are extended in the second direction D2, as shown in FIG. 5.

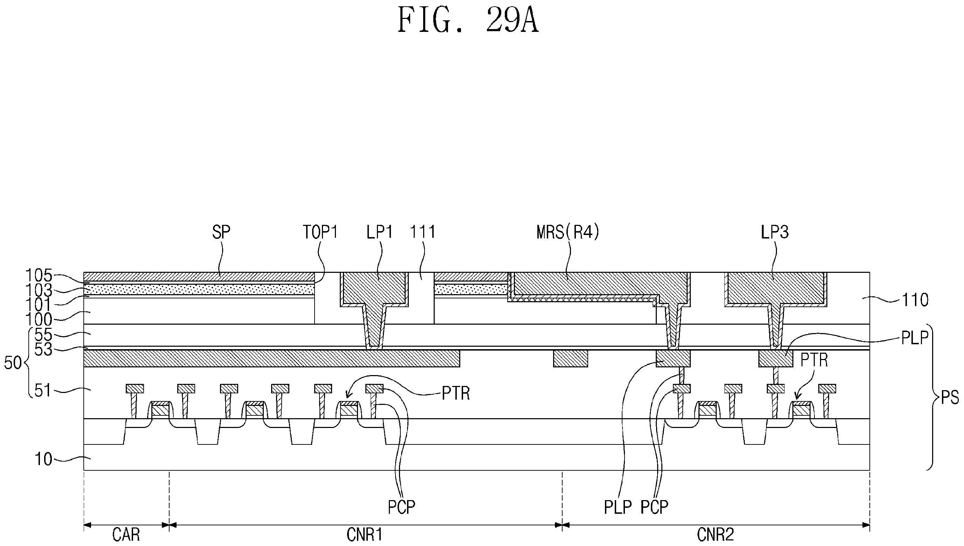

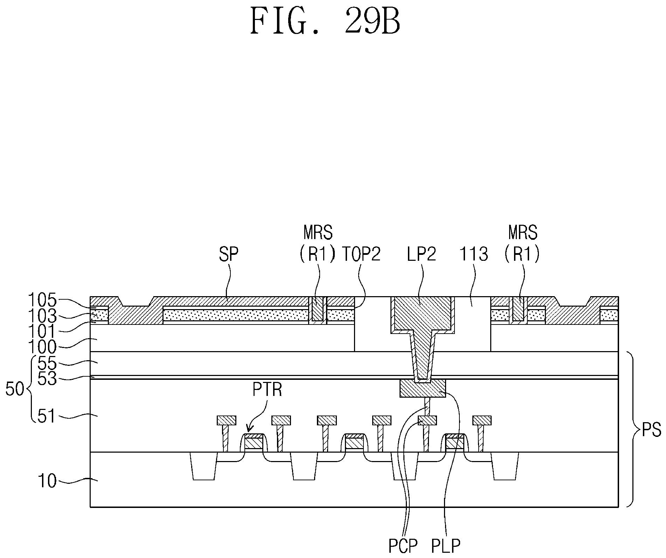

Referring to FIGS. 5, 29A, and 29B, the first, second, and third pad patterns LP1, LP2, and LP3 may be formed in the first, second, and third via holes VH1, VH2, and VH3 and the first, second, and third trenches T1, T2, and T3, and the metal structure MRS may be formed in the fourth via hole VH4 and the fourth trench T4.

The formation of the first, second, and third pad patterns LP1, LP2, and LP3 and the metal structure MRS may include sequentially depositing a barrier metal layer and a metal layer in the first to fourth via holes VH1-VH4 and the first to fourth trenches T1-T4 and then performing a planarization process on the barrier metal layer and the metal layer to expose the top surface of the conductive support layer SP.

In the fourth trench T4, the barrier metal layer may be in direct contact with portions of the semiconductor layer 100, and in this case, the metal-semiconductor compound layer MSC may be formed as a result of reaction between a metallic material in the barrier metal layer and silicon in the semiconductor layer 100.

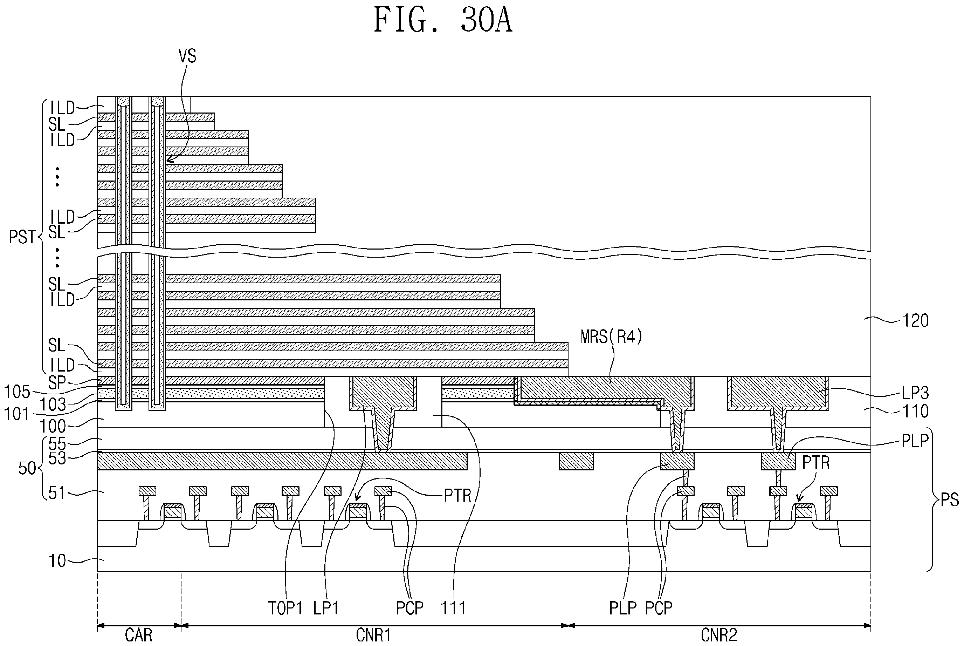

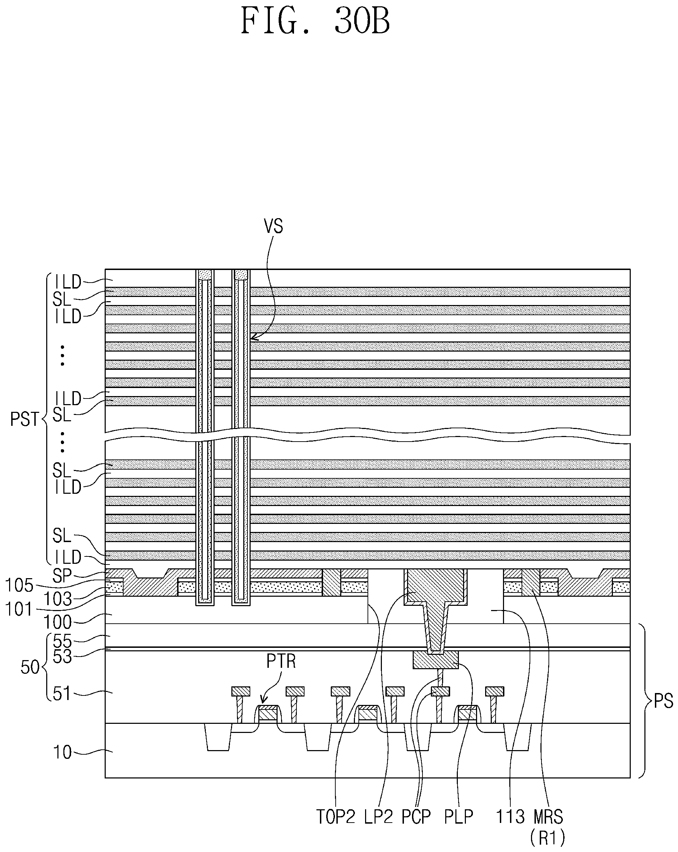

Referring to FIGS. 5, 30A, and 30B, a mold structure PST may be formed by vertically and alternately forming upper sacrificial layers SL and the insulating layers ILD on the conductive support layer SP. The mold structure PST may be formed to have a stepwise structure on the first connection region CNR1.

In the mold structure PST, the upper sacrificial layers SL may be formed of a material that can be etched with a high etch selectivity with respect to the insulating layers ILD. In an implementation, the upper sacrificial layers SL may be formed of an insulating material that is different from the insulating layers ILD. The upper sacrificial layers SL may be formed of or include the same material as the lower sacrificial layer 103. In an implementation, the upper sacrificial layers SL may be formed of or include silicon nitride, and the insulating layers ILD may be formed of or include silicon oxide.

After the formation of the mold structure PST, the planarization insulating layer 120 may be formed on the insulating gapfill layer 110 to cover the staircase structure of the mold structure PST.

Next, the vertical structures VS may be formed to penetrate the mold structure PST.

The formation of the vertical structures VS may include anisotropically etching the mold structure PST, the conductive support layer SP, and the lower sacrificial layer 103, forming vertical holes to penetrate the mold structure PST, the conductive support layer SP, and the lower sacrificial layer 103, and sequentially depositing the data storage pattern DSP (e.g., of FIG. 14) and the vertical semiconductor pattern VP (e.g., of FIG. 14) in each of the vertical holes. In an implementation, the anisotropic etching process to form the vertical holes may be performed in an over-etch manner, and in this case, the top surface of the semiconductor layer 100 may be partially etched such that lower portions of the vertical structures VS are placed in the semiconductor layer 100.

The data storage pattern DSP may be formed to cover inner surfaces of the vertical holes conformally (e.g., to a constant thickness). The data storage pattern DSP may include a tunneling insulating layer, a charge storing layer, and a blocking insulating layer, which are sequentially stacked.

The vertical semiconductor patterns VP may be formed in in the vertical holes, in which the data storage patterns DSP are provided, and bit-line conductive pads may be formed on top portions of the vertical semiconductor patterns VP.

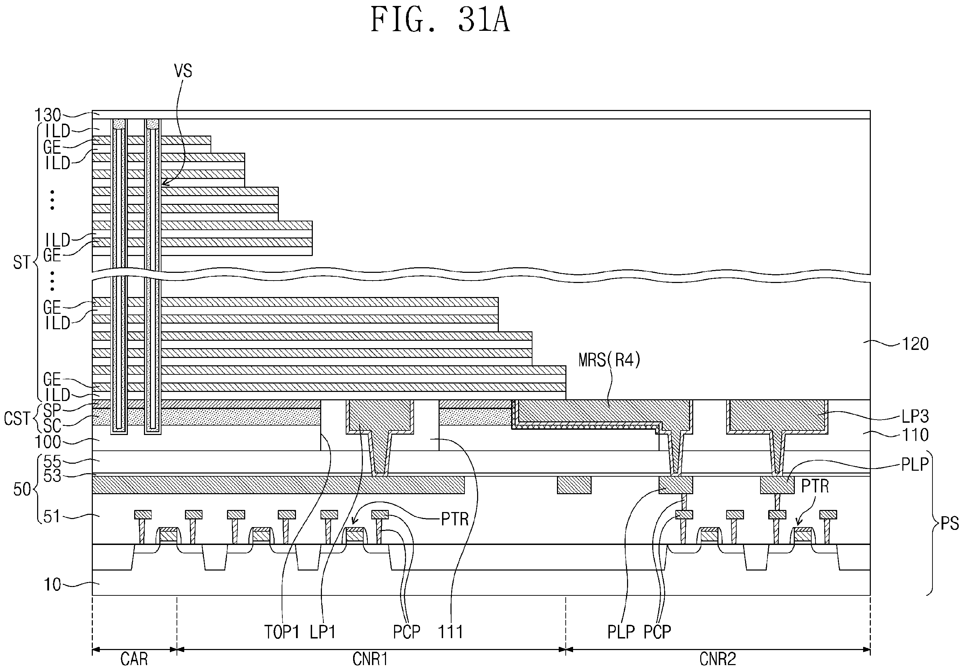

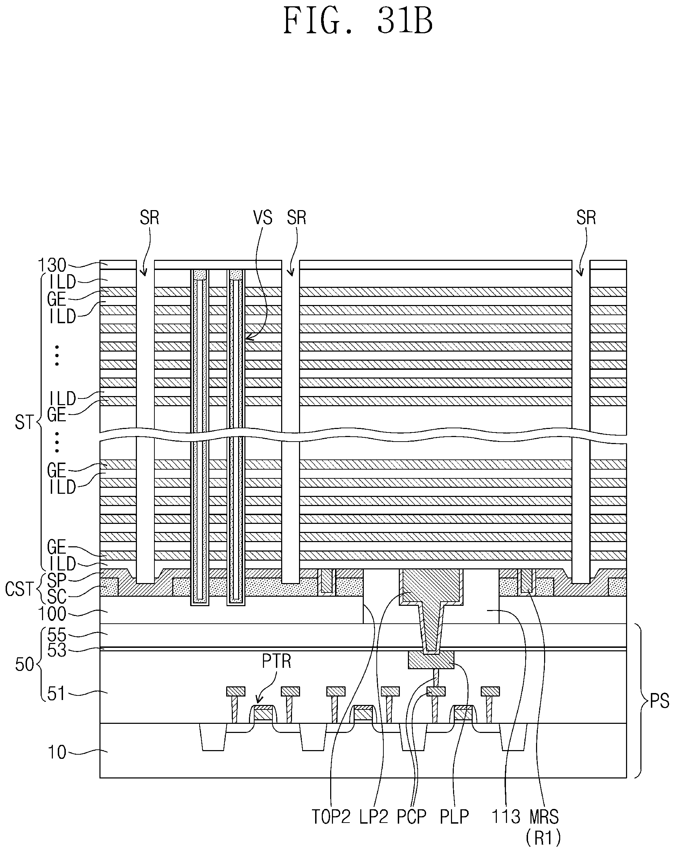

Referring to FIGS. 5, 31A, and 31B, after the formation of the vertical structures VS, the first interlayer insulating layer 130 may be formed on the planarization insulating layer 120 to cover the top surfaces of the vertical structures VS.

Separation trenches SR may be formed to penetrate the mold structure PST and the conductive support layer SP and to expose the lower sacrificial layer 103. The separation trenches SR may be extended along the first direction D1 and the lengths of the separation trenches SR may vary depending on their location.

After the formation of the separation trenches SR, a process may be performed to replace the first buffer insulating layer 101, the lower sacrificial layer 103, and the second buffer insulating layer 105 with the source conductive pattern SC.

The formation of the source conductive pattern SC may include isotropically etching the lower sacrificial layer 103 and first and second buffer insulating layers 101 and 105, which are exposed through the separation trenches. During the isotropic etching process, the data storage pattern DSP (e.g., of FIG. 14) may be partially etched in an isotropic manner, and in this case, portions of the vertical semiconductor patterns VP (e.g., of FIG. 14) may be exposed. The source conductive pattern SC may be formed by depositing a doped poly silicon, after the process of exposing the portions of the vertical semiconductor patterns VP (e.g., of FIG. 14). Accordingly, the source structure CST may be formed between the semiconductor layer 100 and the mold structure PST.

After the formation of the source structure CST, a process may be performed to replace the upper sacrificial layers SL with the electrodes GE, and as a result, the stack ST may be formed to have the afore-described structure. The formation of the stack ST may include isotropically etching the upper sacrificial layers SL using an etch recipe having an etch selectivity with respect to the insulating layers ILD, the vertical structures VS, and the source structure CST. During the isotropic etching process on the upper sacrificial layers SL, the upper sacrificial layers SL may be partially left to form the first and second mold patterns MP1 and MP2.

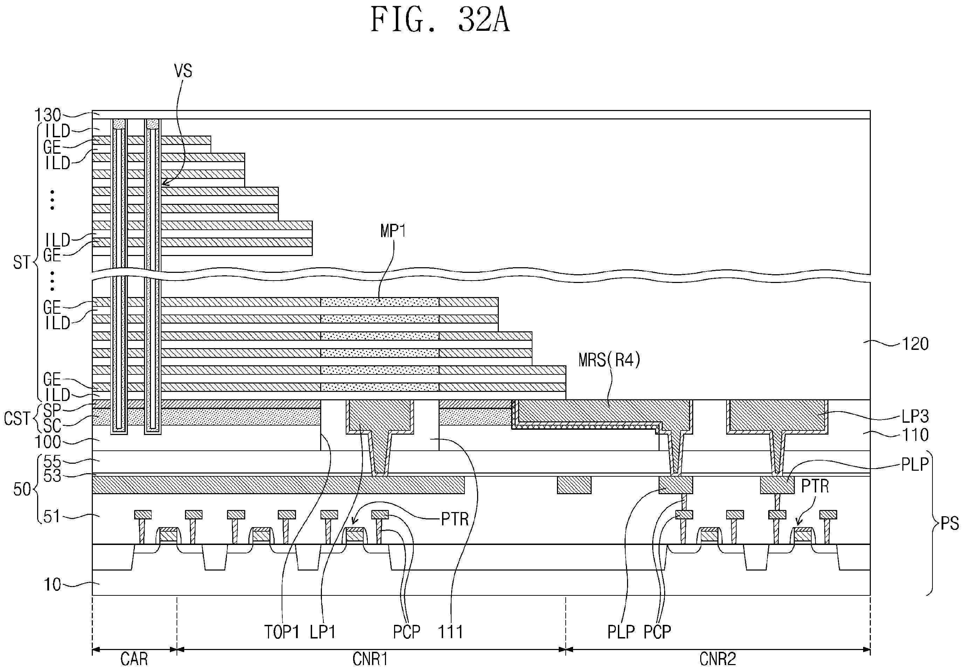

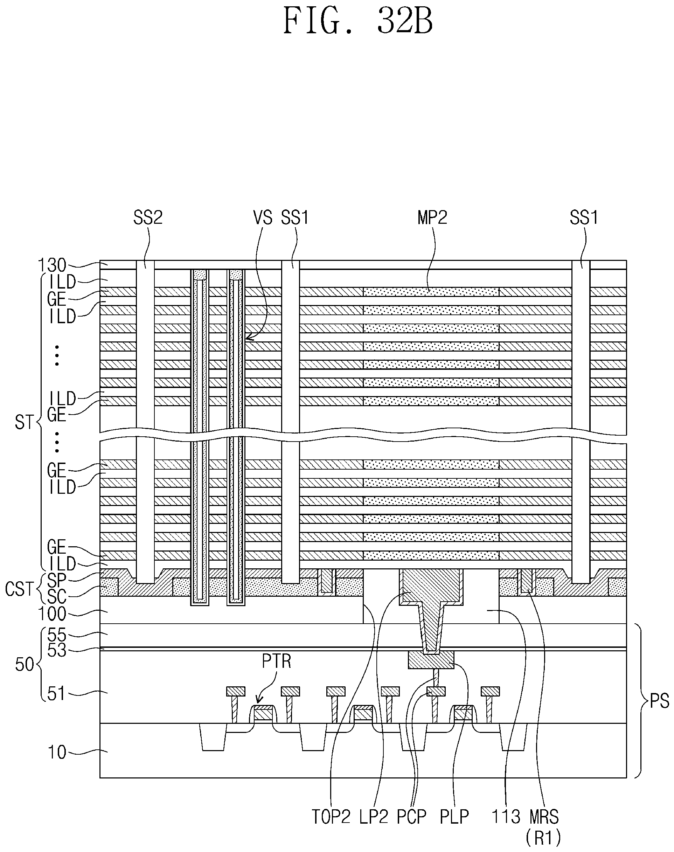

Referring to FIGS. 5, 32A, and 32B, after the formation of the stack ST, the first, second, and third separation structures SS1, SS2, and SS3 may be formed by filling the separation trenches SR with an insulating material.

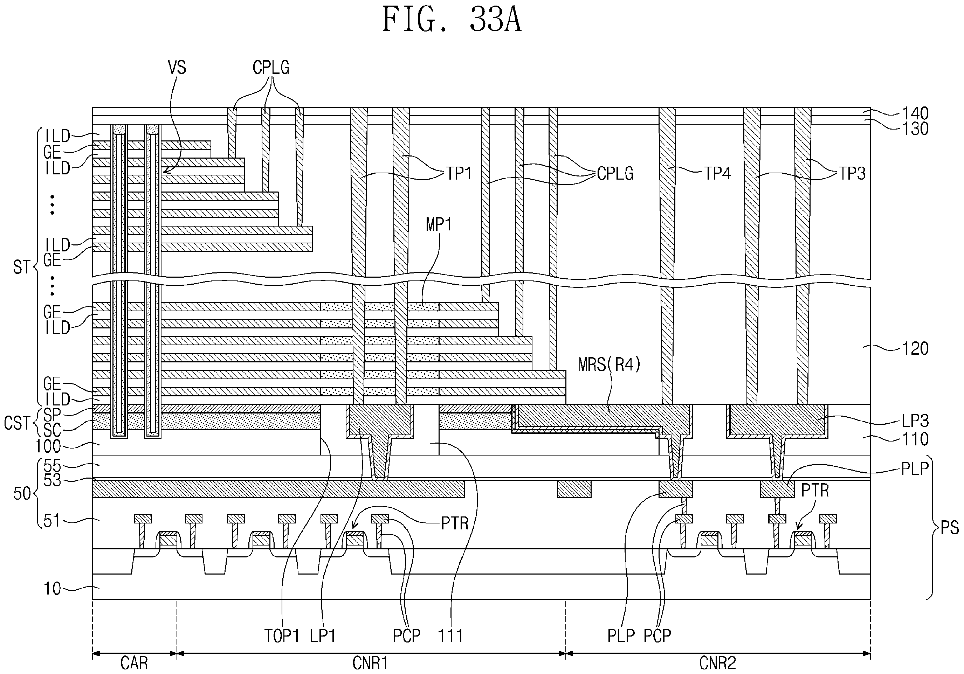

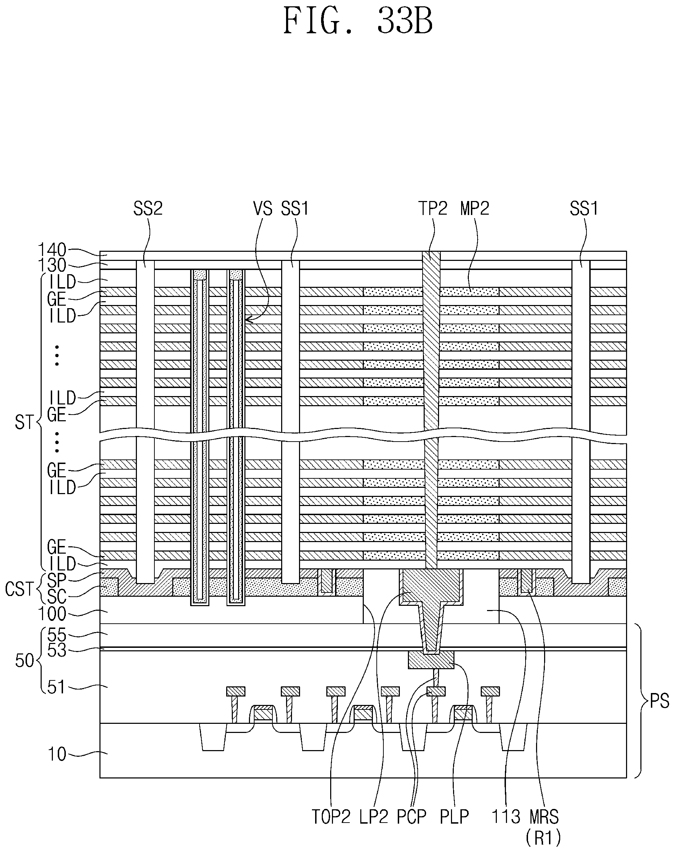

Referring to FIGS. 5, 33A, and 33B, the second interlayer insulating layer 140 may be formed on the first interlayer insulating layer 130, and the cell contact plugs CPLG connected to the stack ST may be formed.

Next, the first to fourth penetration plugs TP1, TP2, TP3, and TP4 may be formed at the same time. The first to fourth penetration plugs TP1, TP2, TP3, and TP4 may be formed of or include at least one of metals and/or metal nitrides.

Referring back to FIGS. 7, 8, and 9, the lower and upper contact plugs LCT and UCT and the connection conductive pattern ICT may be formed in the third and fourth interlayer insulating layers 150 and 160. The bit lines BL and the conductive lines CL may be formed on the fourth interlayer insulating layer 160.

Hereinafter, other examples of the fabricating method will be described below. However, the same features as those in the previously-described embodiment may be omitted, for concise description.

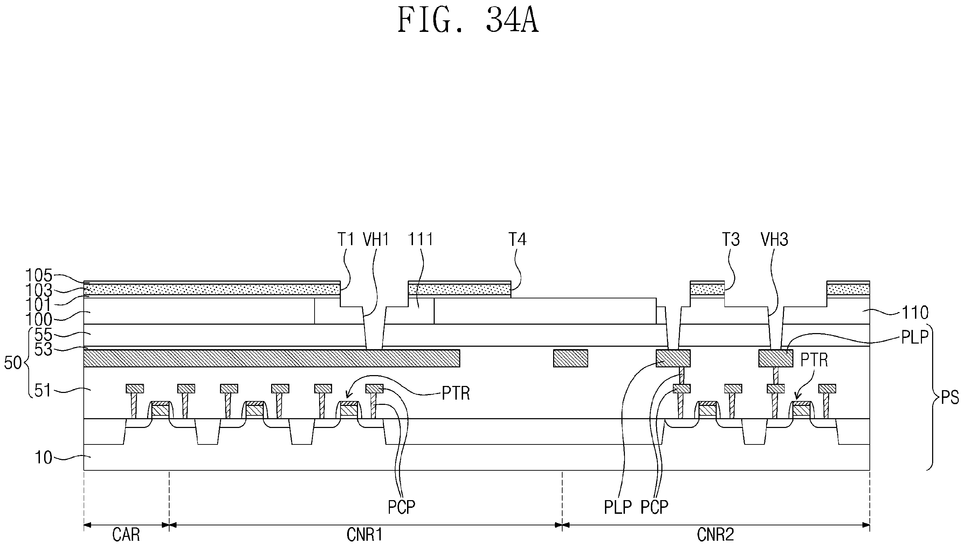

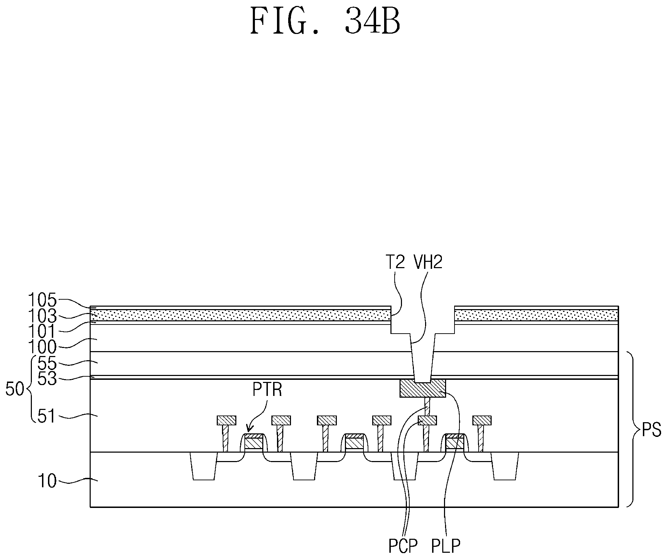

FIGS. 34A to 37A and FIGS. 34B to 37B are sectional views of stages in a method of fabricating a semiconductor device, according to an embodiment.

Referring to FIGS. 34A and 34B, the via holes and the trenches may be formed before the formation of the conductive support layer SP.

In an implementation, the semiconductor layer 100 may be formed on the peripheral circuit structure PS. Thereafter, the first and second insulating patterns 111 and 113 may be formed in the first and second penetration holes TOP1 and TOP2 penetrating the semiconductor layer 100. The insulating gapfill layer 110 may be formed on the lower insulating layer 50 to cover the side surface of the semiconductor layer 100.

Next, the first buffer insulating layer 101, the lower sacrificial layer 103, and the second buffer insulating layer 105 may be sequentially stacked on the semiconductor layer 100, the first and second insulating patterns 111 and 113, and the insulating gapfill layer 110.

The via holes may be formed to expose the landing pads PLP of the peripheral circuit structure PS, and the trenches connected to the via holes may be formed.

The via holes and the trenches may be formed by patterning the first buffer insulating layer 101, the lower sacrificial layer 103, the second buffer insulating layer 105, the first and second insulating patterns 111 and 113, and the insulating gapfill layer 110. The via holes and the trenches may include the first, second, third, and fourth via holes VH1-VH4 and the first, second, third, and fourth trenches T1-T4, as described above.

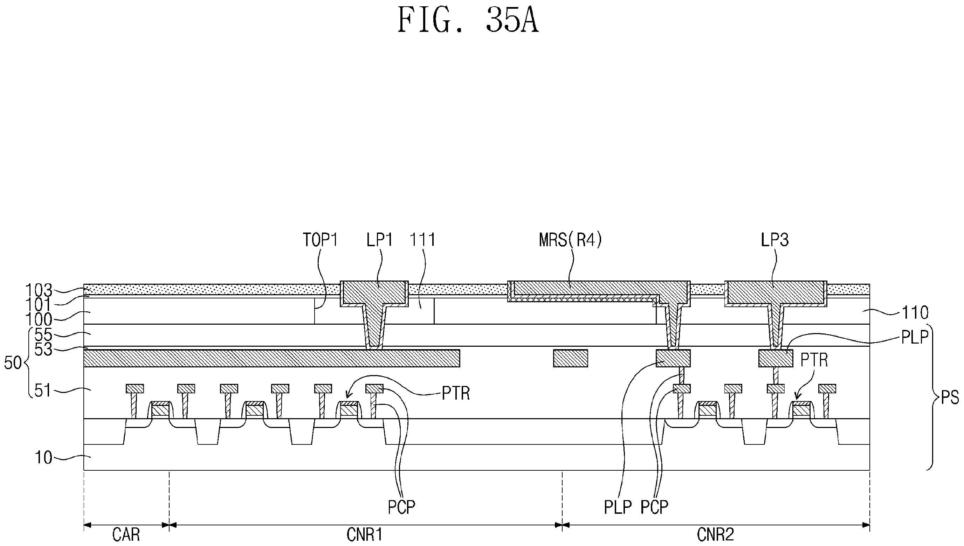

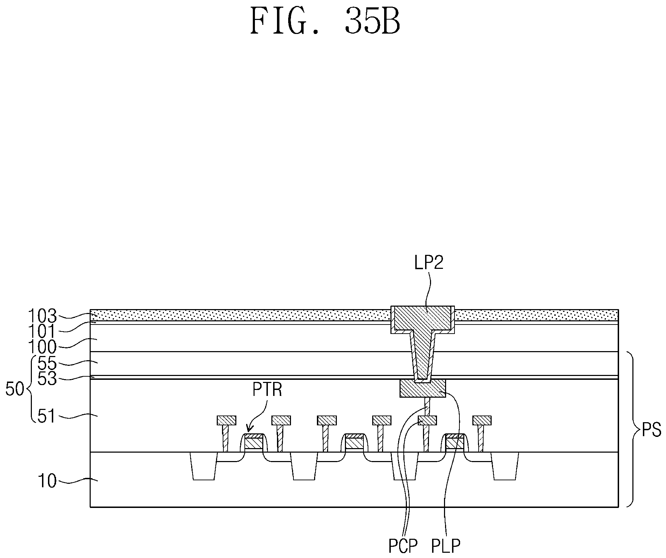

Referring to FIGS. 35A and 35B, a barrier metal layer and a metal layer may be sequentially formed in the via holes VH1-VH4 and the trenches T1-T4, and the barrier metal layer and the metal layer may be planarized to expose the second buffer insulating layer 105 or the lower sacrificial layer 103. Accordingly, the first, second, and third pad patterns LP1, LP2, and LP3 and the metal structure MRS may be formed at the same time. Here, the first, second, and third pad patterns LP1, LP2, and LP3 and the metal structure MRS may have top surfaces that are located at substantially the same level as the top surface of the second buffer insulating layer 105 or the top surface of the lower sacrificial layer 103.

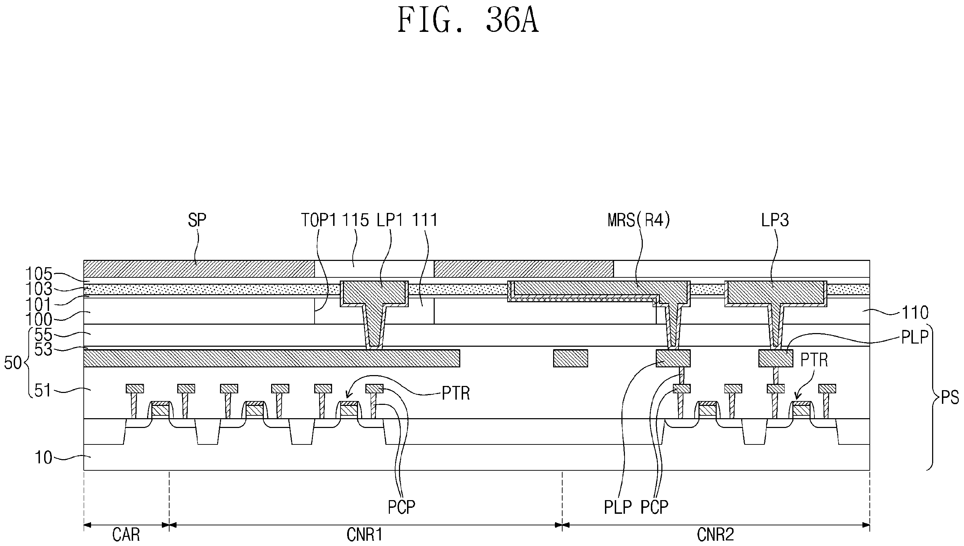

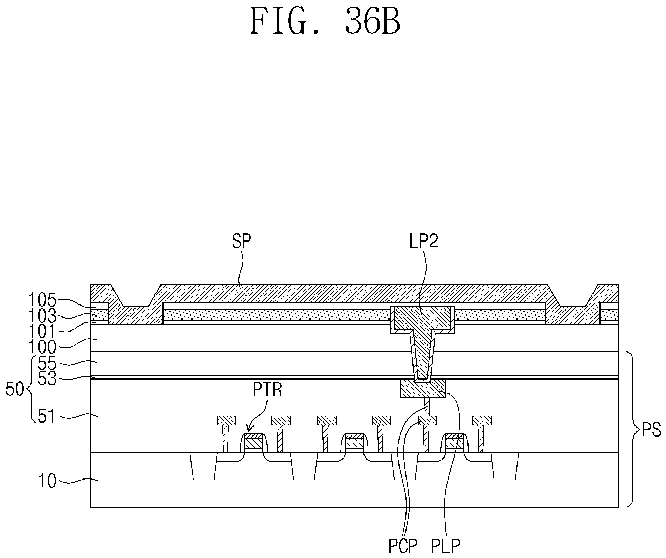

Referring to FIGS. 36A and 36B, the first buffer insulating layer 101, the lower sacrificial layer 103, and the second buffer insulating layer 105 may be formed to have openings exposing portions of the semiconductor layer 100, in the cell array region CAR.

After the formation of the openings, a conductive support layer SP may be formed on the second buffer insulating layer 105 to have a constant thickness. After the formation of the conductive support layer SP, the third insulating pattern 115 may be formed to penetrate the conductive support layer SP. The third insulating pattern 115 may be disposed on the first and second insulating patterns 111 and 113 and the insulating gapfill layer 110.

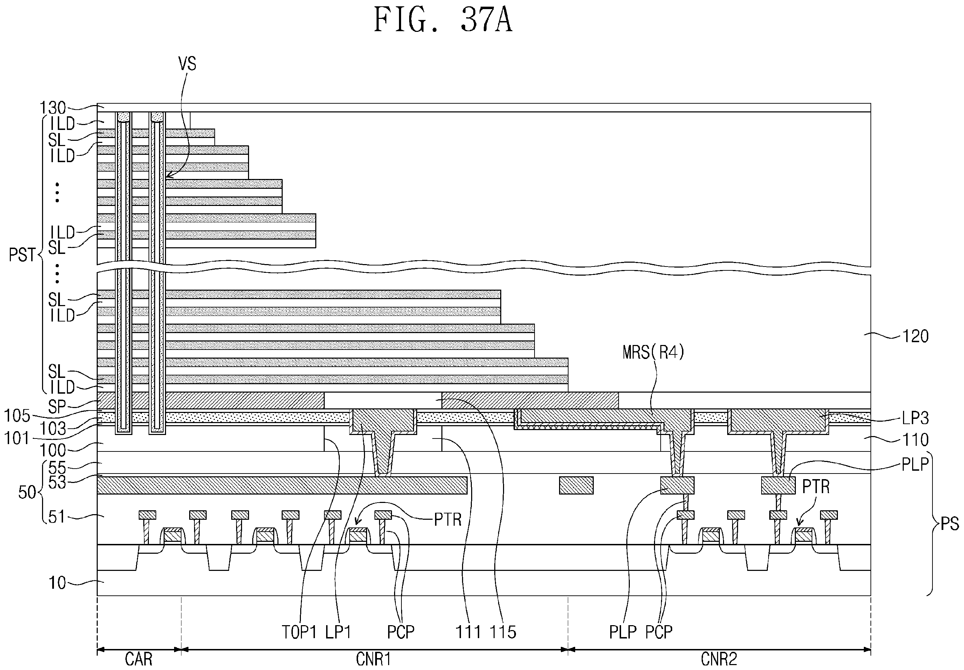

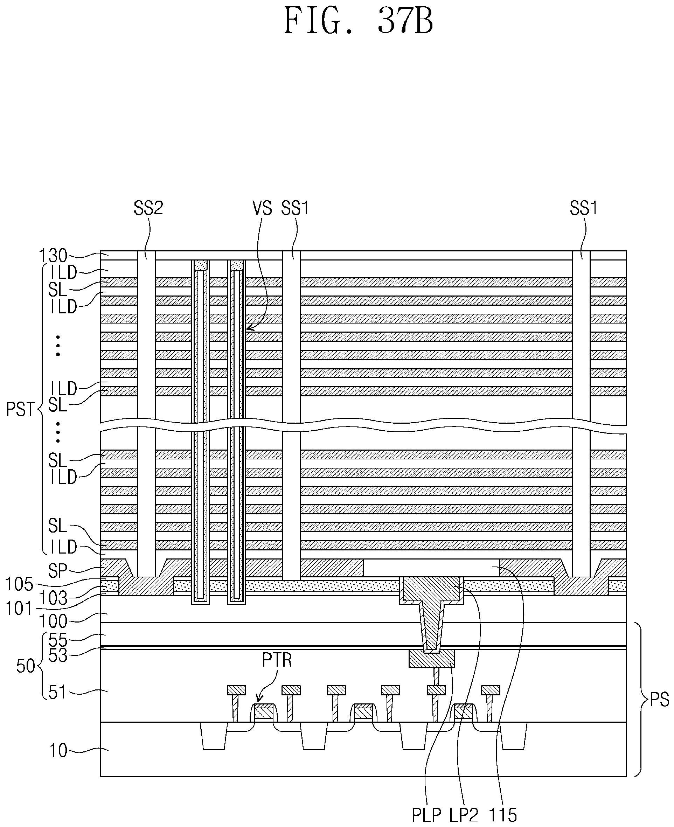

Referring to FIGS. 37A and 37B, the mold structure PST, the insulating gapfill layer 110, and the vertical structures VS, which were previously described with reference to FIGS. 30A and 30B, may be formed on the conductive support layer SP.

Next, as described with reference to FIGS. 31A and 31B, a process may be performed to replace the lower sacrificial layer 103 with the source conductive pattern SC. During the isotropic etching process, which is performed on the lower sacrificial layers 103 to form the source conductive pattern SC, the lower sacrificial layers 103 and the first and second buffer insulating layers 101 and 105 may be partially left near the first insulating pattern 111.

Thereafter, the stack ST, the cell contact plugs CPLG, and the first to fourth penetration plugs TP1-TP4 may be formed, as described with reference to FIGS. 31A, 31B, 32A, and 32B.

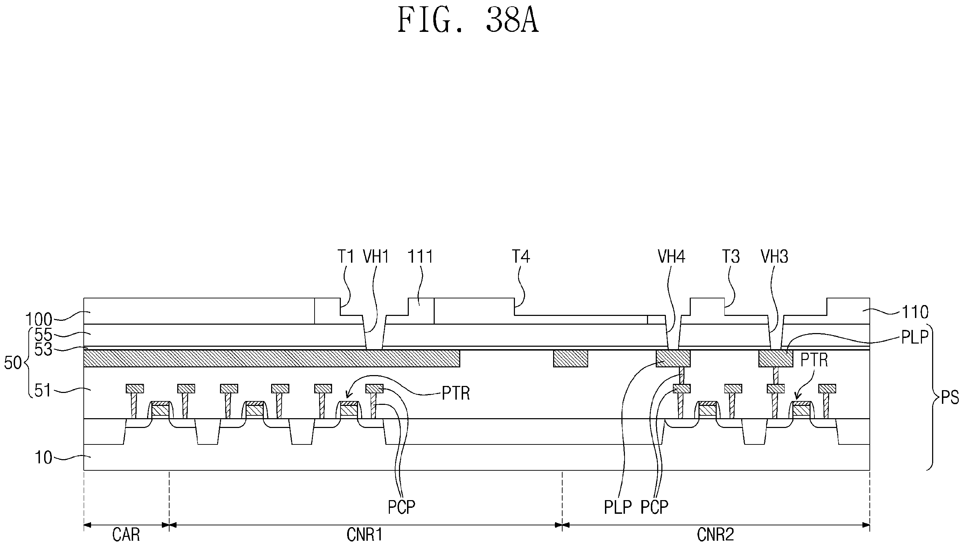

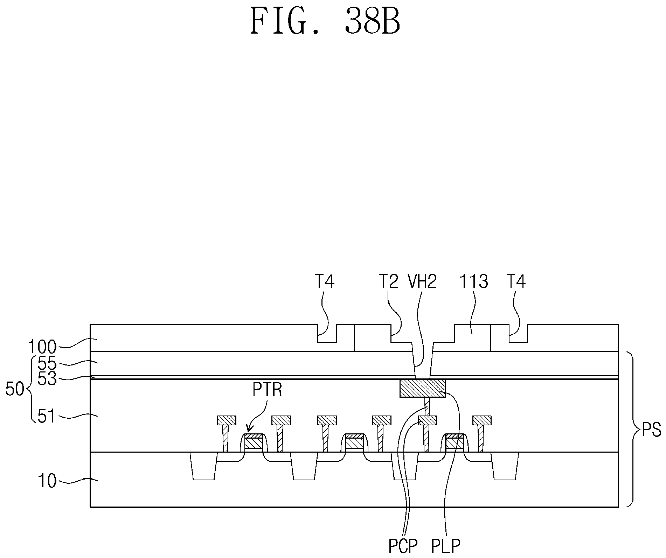

FIGS. 38A to 41A and FIGS. 38B to 41B are sectional views of stages in a method of fabricating a semiconductor device, according to an embodiment.

Referring to FIGS. 38A and 38B, the via holes VH1-VH4 and the trenches T1-T4 may be formed before forming the first buffer insulating layer 101, the lower sacrificial layer 103, and the second buffer insulating layer 105.

In an implementation, the semiconductor layer 100 may be formed on the lower insulating layer 50, and then, the first and second insulating patterns 111 and 113 may be formed in the first and second penetration holes TOP1 and TOP2 penetrating the semiconductor layer 100. Thereafter, the insulating gapfill layer 110 may be formed on the lower insulating layer 50 to cover the side surface of the semiconductor layer 100.

Next, the via holes VH1-VH4 may be formed to expose the landing pads PLP of the peripheral circuit structure PS, and then, the trenches T1-T4 connected to the via holes may be formed.

The via holes VH1-VH4 and the trenches T1-T4 may be formed by patterning the first and second insulating patterns 111 and 113, the insulating gapfill layer 110, and the lower insulating layer 50. As described above, the via holes VH1-VH4 may include the first, second, third, and fourth via holes VH1-VH4 and the trenches T1-T4 may include the first, second, third, and fourth trenches T1-T4.

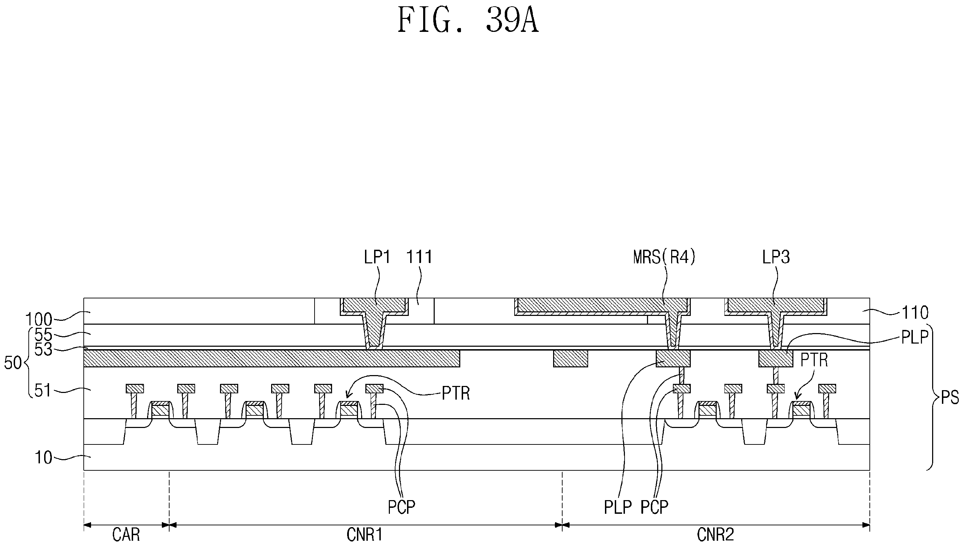

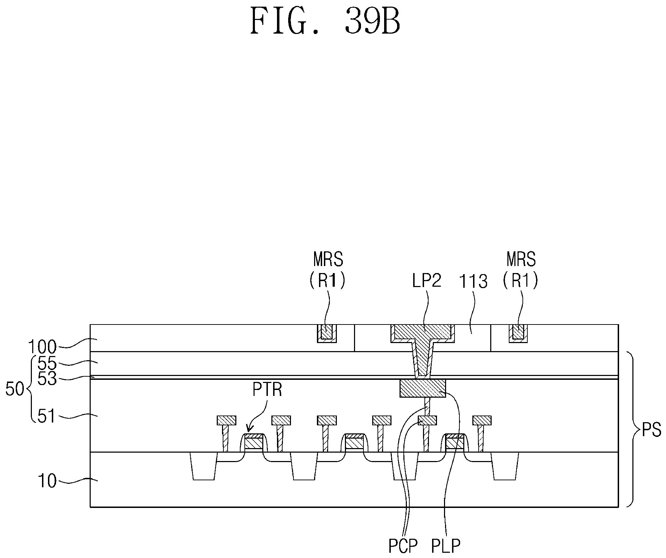

Referring to FIGS. 39A and 39B, a barrier metal layer and a metal layer may be sequentially formed in the via holes VH1-VH4 and the trenches T1-T4 and then may be planarized to expose the second buffer insulating layer 105 or the lower sacrificial layer 103. Accordingly, the first, second, and third pad patterns LP1, LP2, and LP3 and the metal structure MRS may be formed at the same time. Here, the first, second, and third pad patterns LP1, LP2, and LP3 and the metal structure MRS may have top surfaces that are located at substantially the same level as the top surface of the semiconductor layer 100.

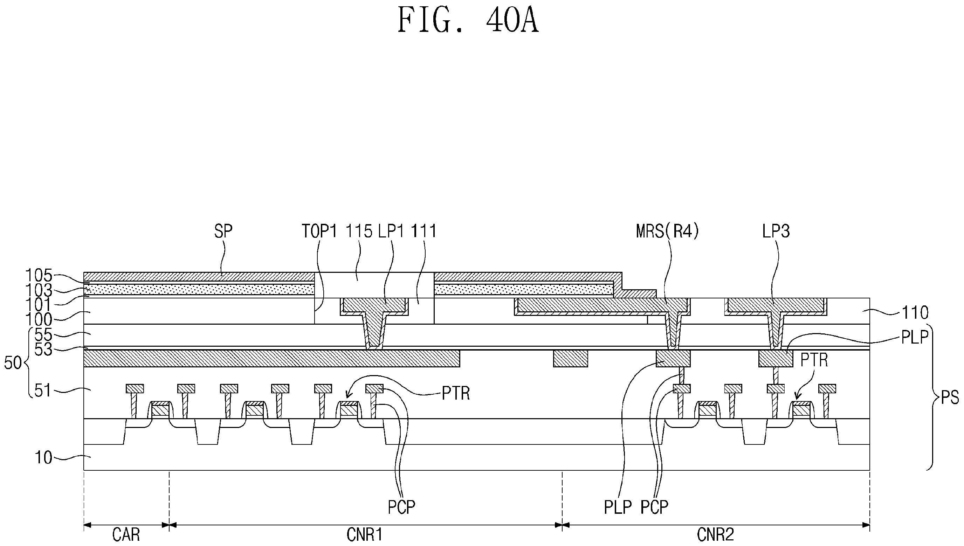

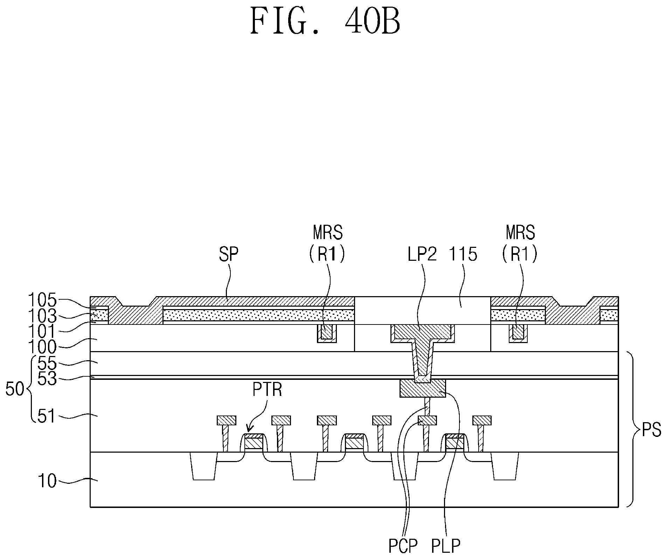

Referring to FIGS. 40A and 40B, the first buffer insulating layer 101, the lower sacrificial layer 103, and the second buffer insulating layer 105 may be sequentially stacked on the semiconductor layer 100, the first, second, and third pad patterns LP1, LP2, and LP3, and the metal structure MRS.

Openings may be formed to penetrate the first buffer insulating layer 101, the lower sacrificial layer 103, and the second buffer insulating layer 105 and to expose some portions of the semiconductor layer 100, and then, the conductive support layer SP may be formed on the second buffer insulating layer 105 to have a substantially uniform thickness.

After the formation of the conductive support layer SP, the third insulating pattern 115 may be formed to penetrate the conductive support layer SP. The third insulating pattern 115 may be on the first and second insulating patterns 111 and 113 and the insulating gapfill layer 110.

In an implementation, after the formation of the first, second, and third pad patterns LP1, LP2, and LP3 and the metal structure MRS, the formation of the first buffer insulating layer 101, the lower sacrificial layer 103, the second buffer insulating layer 105, and the conductive support layer SP may be omitted.

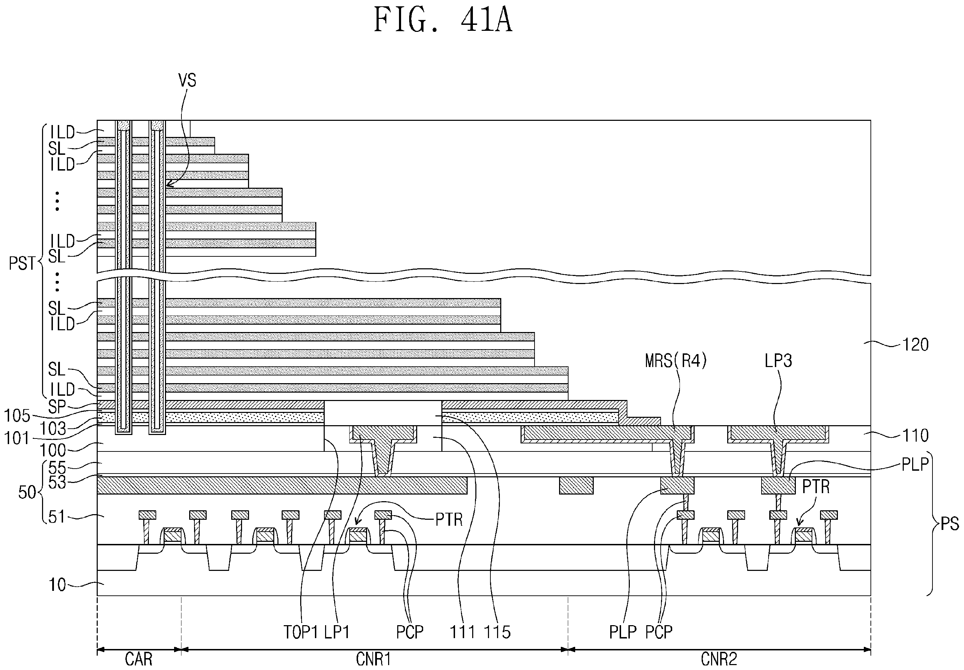

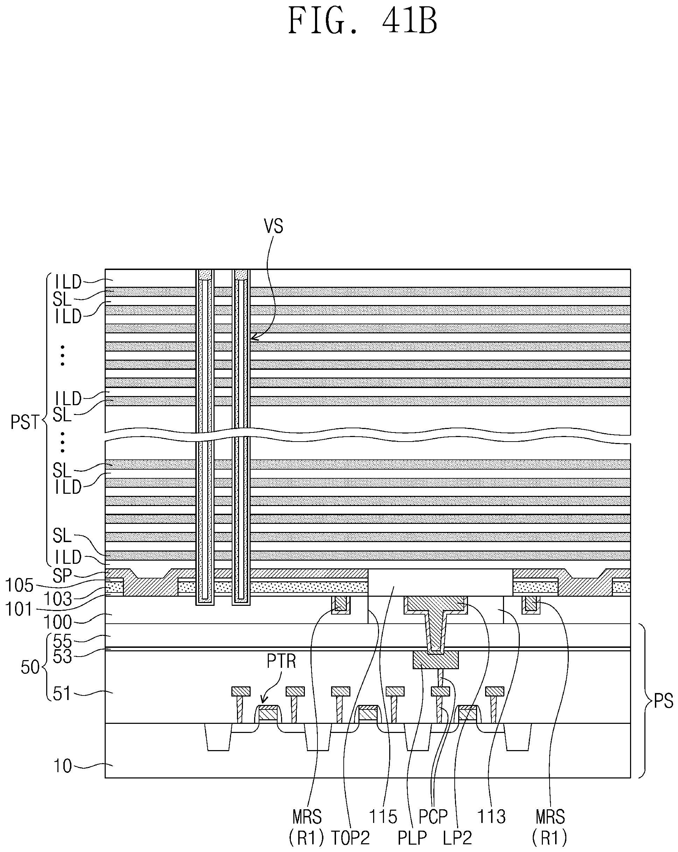

Referring to FIGS. 41A and 41B, the mold structure PST, the insulating gapfill layer 110, and the vertical structures VS, which were previously described with reference to FIGS. 30A and 30B, may be formed on the conductive support layer SP.

Next, a process may be performed to replace the lower sacrificial layers 103 with the source conductive pattern SC, as described with reference to FIGS. 32A and 32B.

Thereafter, the stack ST, the cell contact plugs CPLG, and the first to fourth penetration plugs TP1-TP4 may be formed, as described with reference to FIGS. 32A, 32B, 33A, and 33B.

According to an embodiment, a metal structure may be in contact with a semiconductor layer, and the metal structure may help prevent an increase in resistance of the semiconductor layer, which could otherwise occur due to first and second insulating patterns in the semiconductor layer, when there is a current flowing through the semiconductor layer. Thus, a reduction in an operation speed of the semiconductor device may be prevented. In an implementation, the semiconductor layer and the metal structure may be used as a high-speed current path, between the penetration plugs and the vertical structures, and thus, it is possible to help improve the electric and reliability characteristics of the semiconductor device.

According to an embodiment, the metal structure may be at the same level as first, second, and third pad patterns, and thus, it is possible to easily form the first to fourth penetration plugs connected thereto.

One or more embodiments may provide a semiconductor device with improved reliability and an increased integration density.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor device, comprising:
a semiconductor substrate;
a peripheral circuit structure including peripheral circuits integrated on the semiconductor substrate, and a landing pad connected to the peripheral circuits;
a semiconductor layer on the peripheral circuit structure;
a metal structure in contact with a portion of the semiconductor layer, the metal structure including:
first portions extending in a first direction,
second portions connected to the first portions and extending in a second direction crossing the first direction, and
a via portion vertically extending from at least one of the first and second portions and being connected to the landing pad; and
a stack including insulating layers and electrodes vertically and alternately stacked on the metal structure.

2. The semiconductor device as claimed in claim 1, wherein the stack overlaps with the first and second portions of the metal structure, when viewed in a plan view.

3. The semiconductor device as claimed in claim 1 or claim 2, further comprising a first insulating pattern below the stack, extending in the first direction, and penetrating the semiconductor layer,
wherein the second portions of the metal structure cross the first insulating pattern.

4. The semiconductor device as claimed in claim 3, wherein:
the metal structure has a first thickness on the semiconductor layer and has a second thickness on the first insulating pattern, the second thickness being larger than the first thickness, and
the metal structure has a substantially flat top surface.

5. The semiconductor device as claimed in any preceding claim, wherein the via portion of the metal structure is laterally spaced apart from the semiconductor layer.

6. The semiconductor device as claimed in any preceding claim, further comprising a metal-semiconductor compound layer between the portion of the semiconductor layer and the metal structure.

7. The semiconductor device as claimed in any preceding claim, wherein the metal structure includes a first metal pattern and a first barrier metal pattern, the first barrier metal pattern enclosing side and bottom surfaces of the first metal pattern.

8. The semiconductor device as claimed in any preceding claim, wherein top surfaces of the first and second portions of the metal structure are located at substantially the same level as a top surface of the semiconductor layer.

9. The semiconductor device as claimed in any preceding claim, further comprising:
a source structure between the semiconductor layer and the stack; and
a vertical semiconductor pattern penetrating the stack,
wherein:
the source structure includes first and second source conductive patterns sequentially stacked on the semiconductor layer, and
the first source conductive pattern is in contact with a portion of a side surface of the vertical semiconductor pattern.

10. The semiconductor device as claimed in claim 9, wherein top surfaces of the first and second portions of the metal structure are located at substantially the same level as a top surface of the second source conductive pattern.

11. The semiconductor device as claimed in any preceding claim, further comprising:
a planarization insulating layer covering the stack; and
a penetration plug spaced apart from the stack, penetrating the planarization insulating layer, and being coupled to the metal structure.

12. The semiconductor device as claimed in any preceding claim, further comprising:
a first insulating pattern vertically overlapping with a portion of the stack and penetrating the semiconductor layer;
a first pad pattern in the first insulating pattern and electrically connected to a first landing pad of the peripheral circuit structure; and
a second pad pattern spaced apart from the stack and the semiconductor layer and electrically connected to a second landing pad of the peripheral circuit structure,
wherein the first and second pad patterns include the same metal material as the metal structure.

13. The semiconductor device as claimed in claim 12, wherein top surfaces of the first and second pad patterns are located at substantially the same level as a top surface of the metal structure.

14. The semiconductor device as claimed in claim 12 or claim 13, further comprising:
a first penetration plug penetrating the stack and connected to the first pad pattern; and
a second penetration plug spaced apart from the stack and connected to the second pad pattern.

15. A semiconductor device, comprising:
a semiconductor substrate;
a peripheral circuit structure including peripheral circuits integrated on the semiconductor substrate, and a landing pad connected to the peripheral circuits;
a semiconductor layer on the peripheral circuit structure;
a first insulating pattern penetrating one portion of the semiconductor layer and extending in a first direction;
a metal structure in contact with another portion of the semiconductor layer, the metal structure including first portions extending in the first direction, and second portions connected to the first portions and extending in a second direction crossing the first direction; and
a stack including insulating layers and electrodes vertically and alternately stacked on the metal structure,
wherein the second portions of the metal structure cross the first insulating pattern.
